# EUROPEAN PATENT APPLICATION

(11) **EP 4 753 423 A1**
(43) Date of publication of application: **03.06.2026**
(21) Application number: 25217143.4
(22) Date of filing: 19.11.2025
(51) Int. Cl.: H10K 59/122, H10K 59/124

(54) **DISPLAY DEVICE AND ELECTRONIC DEVICE**

(30) Priority: 25.11.2024 KR 20240169959
(71) Applicant: Samsung Display Co., Ltd., Yongin-si, Gyeonggi-do 17113 (KR)
(72) Inventor: YOU, Chun Gi, Yongin-si (KR)
(74) Representative: Marks & Clerk LLP

(57) **Abstract**

A display device capable of improving image quality by minimizing or reducing a vertical current leakage, an electronic device including the display device, and a method for fabricating a display device are provided. The display device includes: a substrate (SSUB); a reflective electrode (RL) on the substrate; an optical auxiliary layer (OAL) on the reflective electrode; a first electrode (AND) on the optical auxiliary layer; a light emitting stack (IL) on the first electrode; a second electrode on the light emitting stack; a pixel defining layer (PDL) arranged between adjacent first electrodes; a planarization layer (PNS) on the pixel defining layer; and an auxiliary trench (AXT) defined by a top surface of the pixel defining layer, a side surface of the first electrode, and a side surface of the planarization layer.

## Description

### BACKGROUND

### 1. Field

One or more embodiments of the present disclosure relate to a display device, and for example, to a display device capable of improving image quality by minimizing or reducing a vertical current leakage, an electronic device, and a method for fabricating a display device.

### 2. Description of the Related Art

A head mounted display (HMD) is an image display device that is worn on a user's head in the form of glasses or helmet to form a focus at a close distance in front of the user's eyes. The head mounted display may implement virtual reality (VR) or augmented reality (AR).

The head mounted display magnifies an image displayed on a small display device by using a plurality of lenses, and displays the magnified image to a user. Therefore, the display device applied to the head mounted display should need to provide high-resolution images, for example, images with a resolution of 3000 PPI (Pixels Per Inch) or higher. To this end, an organic light emitting diode on silicon (OLEDoS), which is a high-resolution small organic light emitting display device, may be used as the display device applied to the head mounted display. The OLEDoS is an image display device in which organic light emitting diodes (OLED) are arranged on a semiconductor wafer substrate on which a complementary metal oxide semiconductor (CMOS) circuit is arranged.

### SUMMARY

One or more aspects of embodiments of the present disclosure are directed toward a display device capable of improving image quality by minimizing or reducing a vertical current leakage, an electronic device, and a method for fabricating a display device. Additional aspects will be set forth in part in the description which follows and, in part, will be apparent from the description, or may be learned by practice of the presented embodiments of the disclosure.

According to one or more embodiments of the present disclosure, a display device includes: a substrate; a reflective electrode on the substrate; an optical auxiliary layer on the reflective electrode; a first electrode on the optical auxiliary layer; a light emitting stack on the first electrode; a second electrode on the light emitting stack; a pixel defining layer arranged between adjacent first electrodes; a planarization layer on the pixel defining layer; and an auxiliary trench defined by a top surface of the pixel defining layer, a side surface of the first electrode, and a side surface of the planarization layer.

According to one or more embodiments of the present disclosure, an electronic device includes: a display device including a screen, wherein the display device includes: a substrate; a reflective electrode on the substrate; an optical auxiliary layer on the reflective electrode; a first electrode on the optical auxiliary layer; a light emitting stack on the first electrode; a second electrode on the light emitting stack; a pixel defining layer arranged between adjacent first electrodes; a planarization layer on the pixel defining layer; and an auxiliary trench defined by a top surface of the pixel defining layer, a side surface of the first electrode, and a side surface of the planarization layer.

According to one or more embodiments of the present disclosure, there is provided a method for fabricating a display device, the method including: forming an insulating layer on a substrate; sequentially forming a connection electrode layer, a reflective electrode layer, and an auxiliary layer on the insulating layer; removing a portion of the auxiliary layer in a first region of the insulating layer to form a groove in the auxiliary layer; removing the connection electrode layer, the reflective electrode layer and the auxiliary layer in a second region of the insulating layer to form a connection electrode, a reflective electrode, and an optical auxiliary layer in the first region, and form a protrusion protruding in the first region of the insulating layer and a groove recessed in the second region of the insulating layer; forming a first electrode on a top surface of the optical auxiliary layer, a side surface of the optical auxiliary layer, a side surface of the reflective electrode, a side surface of the connection electrode, and a side surface of the protrusion of the insulating layer; forming a preliminary pixel defining layer on a top surface of the first electrode, a side surface of the first electrode, and a bottom surface of the groove of the insulating layer; forming a planarization layer on the preliminary pixel defining layer; planarizing the planarization layer; forming a trench penetrating the planarization layer and the preliminary pixel defining layer in the second region; forming a pixel defining layer defining an emission area and an auxiliary trench by removing the planarization layer and the preliminary pixel defining layer in the first region and removing a portion of the preliminary pixel defining layer in the second region; forming a light emitting stack on the first electrode and the planarization layer; and forming a second electrode on the light emitting stack.

According to one or more embodiments, the image quality of the display device may be improved by minimizing or reducing a vertical current leakage in the light emitting stack.

For example, an auxiliary trench may be formed at the edge of the first electrode so as to disconnect a hole injection layer and a charge generation layer at the edge of the first electrode. The vertical current leakage at the edge of the light emitting stack may be minimized or reduced by the auxiliary trench. Accordingly, the image quality of the display device may be improved. Furthermore, in at least some embodiments, the method for fabricating the display device ensures that the auxiliary trench is precisely formed, which is for maintaining the integrity of the light-emitting stack and protecting from vertical current leakage. In at least some embodiments, this precise fabrication process contributes to the overall enhancement of image quality, making the display device suitable for high-resolution applications such as VR and AR head-mounted displays.

It should be noted that the effects and aspects of the present disclosure are not limited to the above-described effects and aspects, and other effects and aspects which are not described herein will become apparent to those skilled in the art from the following description.

At least some of the above and other features of the invention are set out in the claims.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects and features of the present disclosure will become more apparent and appreciated from the following descriptions of example embodiments thereof with reference to the accompanying drawings, in which:
FIG. 1 is an exploded perspective view showing a display device according to one or more embodiments of the present disclosure;
FIG. 2 is a block diagram illustrating a display device according to one or more embodiments of the present disclosure;
FIG. 3 is an equivalent circuit diagram of a first sub-pixel according to one or more embodiments of the present disclosure;
FIG. 4 is a layout diagram illustrating an example of a display panel according to one or more embodiments of the present disclosure;
FIG. 5 and FIG. 6 are each a layout diagram illustrating an example of the display area of FIG. 4 according to one or more embodiments of the present disclosure;
FIG. 7 is a cross-sectional view illustrating an example of a display panel taken along the line I1-I1' of FIG. 5 according to one or more embodiments of the present disclosure;
FIG. 8 is a cross-sectional view showing area A1 of FIG. 7 in more detail according to one or more embodiments of the present disclosure;
FIG. 9 is an enlarged view of area A2 of FIG. 8 according to one or more embodiments of the present disclosure;
FIG. 10 is a cross-sectional view of a display device of one or more embodiments of the present disclosure;
FIGS. 11, 12, 13, 14, 15, 16, 17, 18, and 19 are process cross-sectional views illustrating a method for fabricating a display device according to one or more embodiments of the present disclosure;
FIG. 20 is a perspective view illustrating a head mounted display according to one or more embodiments of the present disclosure;
FIG. 21 is an exploded perspective view illustrating an example of the head mounted display of FIG. 20 according to one or more embodiments of the present disclosure;
FIG. 22 is a perspective view illustrating a head mounted display according to one or more embodiments of the present disclosure;
FIG. 23 is a block diagram of an electronic device according to one or more embodiments of present disclosure; and
FIGS. 24, 25, and 26 are each a schematic diagram illustrating electronic devices according to one or more embodiments of the present disclosure.

### DETAILED DESCRIPTION

The present disclosure will now be described more fully hereinafter with reference to the accompanying drawings, in which example embodiments of present disclosure are shown. This disclosure may, however, be embodied in different forms and should not be construed as limited to one or more embodiments set forth herein. Rather, these embodiments are provided so that this disclosure will be thorough and complete, and will fully convey the scope of the present disclosure to those skilled in the art.

It will also be understood that if (e.g., when) a layer is referred to as being "on" another layer or substrate, it may be directly on the other layer or substrate, or one or more intervening layers may also be present therebetween. In contrast, "directly on" may refer to that there are no additional intervening elements or layers between the element or layer and the another element or layer. The same or like reference numbers indicate the same or like components throughout the disclosure. In the accompanied drawings, the thickness of layers and regions may be exaggerated for clarity.

Although the terms "first", "second", and/or the like. may be used herein to describe one or more suitable elements, these elements, should not be limited by these terms. These terms may be used to distinguish one element from another element. Thus, a first element discussed may be termed a second element without departing from teachings of one or more embodiments. The description of an element as a "first" element may not require or imply the presence of a second element or other elements. The terms "first", "second", and/or the like may also be used herein to differentiate different categories or sets of elements. For conciseness, in one or more embodiments, the terms "first", "second", and/or the like may represent "first-category (or first-set)", "second-category (or second-set)", and/or the like, respectively.

Features of one or more suitable embodiments of the present disclosure may be combined partially or totally. As will be clearly appreciated by those skilled in the art, technically one or more suitable interactions and operations are possible. Various embodiments may be practiced individually or in combination.

Hereinafter, one or more embodiments of the present disclosure will be described with reference to the accompanying drawings.

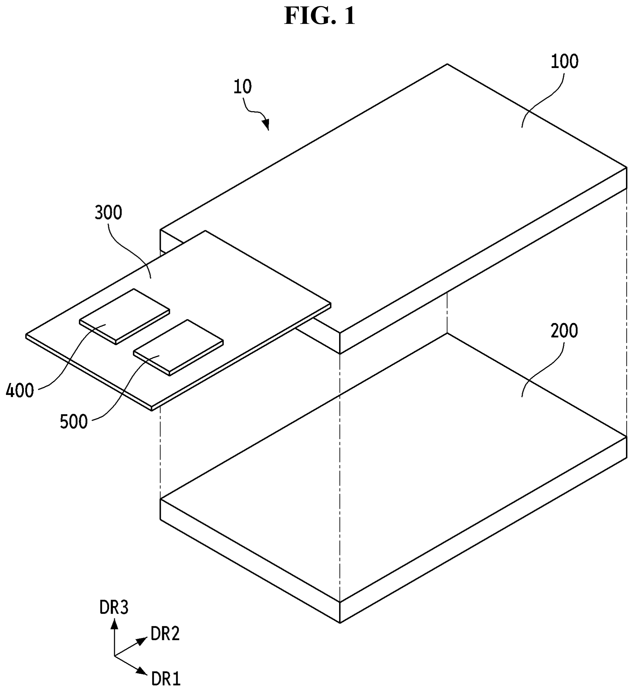

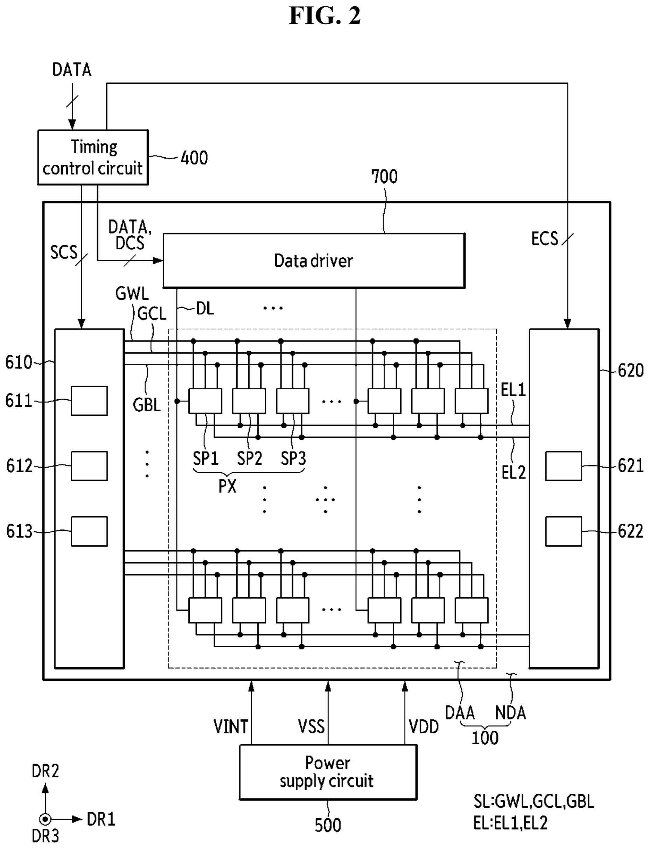

FIG. 1 is an exploded perspective view showing a display device according to one or more embodiments of the present disclosure. FIG. 2 is a block diagram illustrating a display device according to one or more embodiments of the present disclosure.

Referring to FIG. 1 and FIG. 2, a display device 10 according to one or more embodiments is a device displaying a moving image or a still image. The display device 10 according to one or more embodiments may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC) and/or the like. For example, the display device 10 according to one or more embodiments may be applied as a display unit of a television, a laptop, a monitor, a billboard, or an Internet-of-Things (IoT) terminal. In one or more embodiments, the display device 10 may be applied to a smart watch, a watch phone, a head mounted display (HMD) for implementing virtual reality and/or augmented reality, and/or the like.

The display device 10 according to one or more embodiments includes a display panel 100, a heat dissipation layer 200, a circuit board 300, a timing control circuit 400, and a power supply circuit 500.

In one or more embodiments, the display panel 100 may have a planar shape, for example, similar to a quadrilateral shape. For example, the display panel 100 may have a planar shape, similar to a quadrilateral shape, that has a short side of a first direction DR1 and a long side of a second direction DR2 intersecting the first direction DR1. In the display panel 100, a corner where the short side in the first direction DR1 and the long side in the second direction DR2 meet may be right-angled or rounded with a set or predetermined curvature. The planar shape of the display panel 100 is not limited to a quadrilateral shape, and may be a shape similar to another polygonal shape, a circular shape, or an elliptical shape. A planar shape of the display device 10 may conform to the planar shape of the display panel 100, but one or more embodiments of the present disclosure is not limited thereto.

The display panel 100 includes a plurality of pixels PX, a plurality of scan lines SL, a plurality of emission control lines EL, a plurality of data lines DL, a scan driver 610, an emission driver 620, and a data driver 700. The display panel 100 may be divided into a display area DAA displaying an image and a non-display area NDA not displaying an image as shown in FIG. 2.

The plurality of pixels PX may be arranged in the display area DAA. In one or more embodiments, the plurality of pixels PX may be arranged in a matrix form in the first direction DR1 and the second direction DR2. The plurality of scan lines SL and the plurality of emission control lines EL may extend in the first direction DR1, while being arranged in the second direction DR2. The plurality of data lines DL may extend in the second direction DR2, while being arranged with one another in the first direction DR1.

The plurality of scan lines SL includes a plurality of write scan lines GWL, a plurality of control scan lines GCL, and a plurality of bias scan lines GBL. The plurality of emission control lines EL includes a plurality of first emission control lines EL1 and a plurality of second emission control lines EL2.

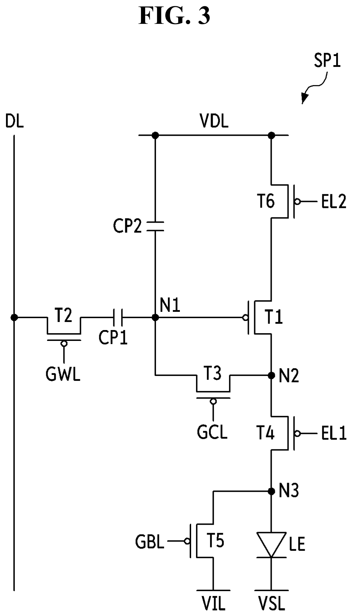

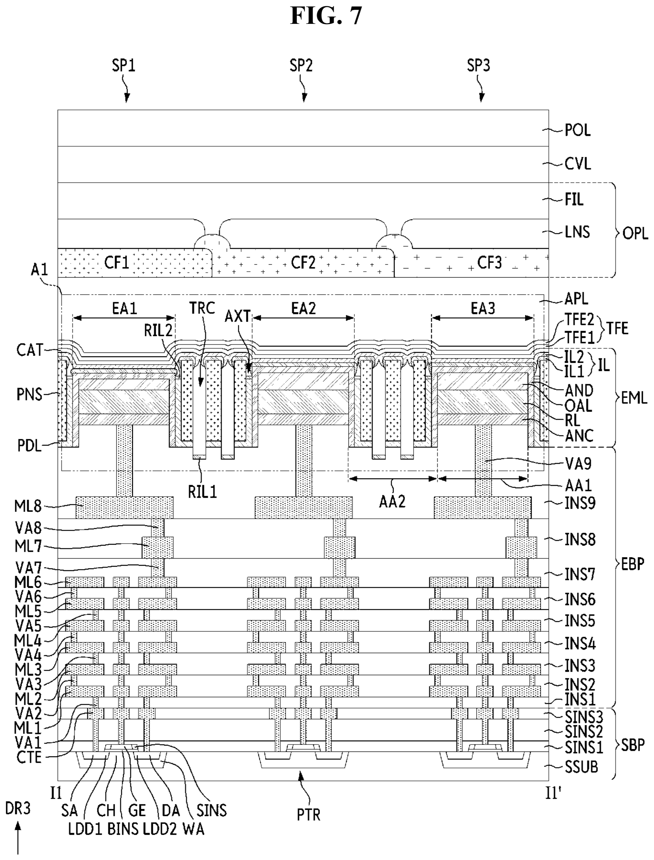

The plurality of pixels PX includes a plurality of sub-pixels SP1, SP2, and SP3. The plurality of sub-pixels SP1, SP2, and SP3 may each include a plurality of pixel transistors as shown in FIG. 3, and the plurality of pixel transistors may be formed by a semiconductor process and arranged on a semiconductor substrate SSUB (see FIG. 7). For example, in one or more embodiments, the plurality of pixel transistors of the data driver 700 may be formed of complementary metal oxide semiconductor (CMOS), but embodiments of the present disclosure are not limited thereto.

Each of the plurality of sub-pixels SP1, SP2, and SP3 may be connected to a (e.g., any one) write scan line GWL selected from among the plurality of write scan lines GWL, a (e.g., any one) control scan line GCL selected from among the plurality of control scan lines GCL, a (e.g., any one) bias scan line GBL selected from among the plurality of bias scan lines GBL, a (e.g., any one) first emission control line EL1 selected from among the plurality of first emission control lines EL1, a (e.g., any one) second emission control line EL2 selected from among the plurality of second emission control lines EL2, and a (e.g., any one) data line DL selected from among the plurality of data lines DL. Each of the plurality of sub-pixels SP1, SP2, and SP3 may receive a data voltage of the data line DL in response to a write scan signal of the write scan line GWL, and emit light from a light emitting element according to the data voltage.

In one or more embodiments, the scan driver 610, the emission driver 620, and the data driver 700 may each be arranged in the non-display area NDA.

The scan driver 610 includes a plurality of scan transistors, and the emission driver 620 includes a plurality of light emitting transistors. The plurality of scan transistors and the plurality of light emitting transistors may be formed on the semiconductor substrate SSUB (see FIG. 7) through a semiconductor process. For example, in one or more embodiments, the plurality of scan transistors and the plurality of light emitting transistors may be formed of CMOS, but embodiments of the present disclosure are not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 includes a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines EL1. The second emission control driver 622 may generate second emission control signals according to the emission timing control signal ECS and sequentially output them to the second emission control lines EL2.

The data driver 700 may include a plurality of data transistors, and the plurality of data transistors may be formed on the semiconductor substrate SSUB (see FIG. 7) through a semiconductor process. For example, in one or more embodiments, the plurality of data transistors may be formed of CMOS, but embodiments of the present disclosure are not limited thereto.

The data driver 700 may receive digital video data DATA and a data timing control signal DCS from the timing control circuit 400. The data driver 700 converts the digital video data DATA into analog data voltages according to the data timing control signal DCS and outputs the analog data voltages to data lines DL. In this regard, the sub-pixels SP1, SP2, and SP3 may be selected by the write scan signal of the scan driver 610, and data voltages (e.g., analog data voltages) may be supplied to the selected sub-pixels SP1, SP2, and SP3.

The heat dissipation layer 200 may overlap the display panel 100 in a third direction DR3, which is a thickness direction of the display panel 100. The heat dissipation layer 200 may be arranged on a (e.g., one) surface of the display panel 100, for example, on the rear surface thereof. The heat dissipation layer 200 serves to dissipate heat generated from the display panel 100. The heat dissipation layer 200 may include a metal layer having high thermal conductivity, such as graphite, silver (Ag), copper (Cu), and/or aluminum (Al).

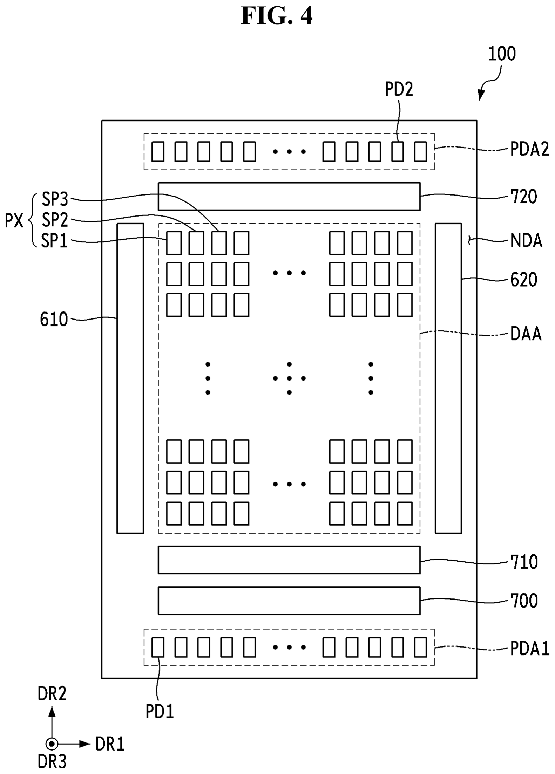

The circuit board 300 may be electrically connected to a plurality of first pads PD1 (see FIG. 4) of a first pad portion PDA1 (see FIG. 4) of the display panel 100 by using a conductive adhesive member such as an anisotropic conductive film. In one or more embodiments, the circuit board 300 may be a flexible printed circuit board with a flexible material, or a flexible film. Although the circuit board 300 is illustrated in FIG. 1 as being unfolded, the circuit board 300 may be bent. In this regard, one end of the circuit board 300 may be arranged on the rear surface of the display panel 100 and/or the rear surface of the heat dissipation layer 200. The other end of the circuit board 300 may be connected to the plurality of first pads PD1 (see FIG. 4) of the first pad portion PDA1 (see FIG. 4) of the display panel 100 by using a conductive adhesive member. The one end of the circuit board 300 may be an opposite end of the other end of the circuit board 300.

The timing control circuit 400 may receive digital video data and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data DATA and the data timing control signal DCS to the data driver 700.

The power supply circuit 500 may generate a plurality of panel driving voltages according to a power voltage from the outside. For example, in one or more embodiments, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT will be described in more detail later in conjunction with FIG. 3.

Each of the timing control circuit 400 and the power supply circuit 500 may be formed as an integrated circuit (IC) and attached to one surface of the circuit board 300. In this regard, the scan timing control signal SCS, the emission timing control signal ECS, digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

In one or more embodiments, each of the timing control circuit 400 and the power supply circuit 500 may be arranged in the non-display area NDA of the display panel 100, similarly to the scan driver 610, the emission driver 620, and the data driver 700. In these embodiments, the timing control circuit 400 may include a plurality of timing transistors, and the power supply circuit 500 may include a plurality of power transistors. The plurality of timing transistors and the plurality of power transistors may be formed on the semiconductor substrate SSUB (see FIG. 7) through a semiconductor process. For example, in one or more embodiments, the plurality of timing transistors and the plurality of power transistors may be formed of CMOS, but embodiments of the present disclosure are not limited thereto. In one or more embodiments, each of the timing control circuit 400 and the power supply circuit 500 may be arranged between the data driver 700 and the first pad portion PDA1 (see FIG. 4).

FIG. 3 is an equivalent circuit diagram of a first sub-pixel according to one or more embodiments of the present disclosure.

Referring to FIG. 3, the first sub-pixel SP1 may be connected to the write scan line GWL, the control scan line GCL, the bias scan line GBL, the first emission control line EL1, the second emission control line EL2, and the data line DL. Further, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. For example, in one or more embodiments, the first driving voltage line VSL may be a low potential voltage line, the second driving voltage line VDL may be a high potential voltage line, and the third driving voltage line VIL may be an initialization voltage line. In these embodiments, the first driving voltage VSS may be lower than the third driving voltage VINT. The second driving voltage VDD may be higher than the third driving voltage VINT.

In one or more embodiments, the first sub-pixel SP1 includes a plurality of transistors T1 to T6, a light emitting element LE, a first capacitor CP1, and a second capacitor CP2.

The light emitting element LE emits light in response to a driving current flowing through the channel of the first transistor T1. The emission amount (e.g., emission intensity) of the light emitting element LE may be proportional to the driving current (Ids). The light emitting element LE may be arranged between a fourth transistor T4 and the first driving voltage line VSL. A first electrode of the light emitting element LE may be connected to a drain electrode of the fourth transistor T4, and a second electrode thereof may be connected to the first driving voltage line VSL. The first electrode of the light emitting element LE may be an anode electrode, and the second electrode of the light emitting element LE may be a cathode electrode. In one or more embodiments, the light emitting element LE may be an organic light emitting diode including a first electrode, a second electrode, and an organic light emitting layer arranged between the first electrode and the second electrode, but embodiments of the present disclosure are not limited thereto. For example, in one or more embodiments, the light emitting element LE may be an inorganic light emitting element including a first electrode, a second electrode, and an inorganic semiconductor arranged between the first electrode and the second electrode, in these embodiments, the light emitting element LE may be a micro light emitting diode.

The first transistor T1 may be a driving transistor that controls a source-drain current (Ids) (hereinafter referred to as "driving current") flowing between a source electrode and a drain electrode thereof according to a voltage applied to a gate electrode thereof. The first transistor T1 includes the gate electrode connected to a first node N1, the source electrode connected to a drain electrode of a sixth transistor T6, and the drain electrode connected to a second node N2.

A second transistor T2 may be arranged between the first electrode of the first capacitor CP1 and the data line DL. The second transistor T2 is turned on by the write scan signal of the write scan line GWL to connect the first electrode of the first capacitor CP1 to the data line DL. Accordingly, the data voltage of the data line DL may be applied to the first electrode of the first capacitor CP1. The second transistor T2 includes a gate electrode connected to the write scan line GWL, a source electrode connected to the data line DL, and a drain electrode connected to the first electrode of the first capacitor CP1.

A third transistor T3 may be arranged between the first node N1 and the second node N2. The third transistor T3 is turned on by the write control signal of the write control line GCL to connect the first node N1 to the second node N2. For this reason, if (e.g., when) the gate electrode and the drain electrode of the first transistor T1 are connected, the first transistor T1 may operate like a diode. The third transistor T3 includes a gate electrode connected to the write control line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light emitting element LE. The fourth transistor T4 includes a gate electrode connected to the first emission control line EL1, a source electrode connected to the second node N2, and a drain electrode connected to the third node N3.

A fifth transistor T5 may be arranged between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE. The fifth transistor T5 includes a gate electrode connected to the bias scan line GBL, a source electrode connected to the third node N3, and a drain electrode connected to the third driving voltage line VIL.

The sixth transistor T6 may be arranged between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor CP1 is formed between the first node N1 and the drain electrode of the second transistor T2. The first capacitor CP1 includes a first electrode connected to the drain electrode of the second transistor T2 and a second electrode connected to the first node N1.

The second capacitor CP2 is formed between the gate electrode of the first transistor T1 and the second driving voltage line VDL. The second capacitor CP2 includes a first electrode connected to the gate electrode of the first transistor T1 and a second electrode connected to the second driving voltage line VDL.

The first node N1 is a junction between the gate electrode of the first transistor T1, the drain electrode of the third transistor T3, the second electrode of the first capacitor CP1, and the first electrode of the second capacitor CP2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light emitting element LE.

Each of the first to sixth transistors T1 to T6 may be a metal-oxide-semiconductor field effect transistor (MOSFET). For example, in one or more embodiments, each of the first to sixth transistors T1 to T6 may be a P-type (kind) MOSFET, but embodiments of the present disclosure are not limited thereto. For example, in one or more embodiments, each of the first to sixth transistors T1 to T6 may be an N-type (kind) MOSFET. In one or more embodiments, some of the first to sixth transistors T1 to T6 may be P-type (kind) MOSFETs, and each of the remaining transistors may be an N-type (kind) MOSFET.

Although it is illustrated in FIG. 3 that the first sub-pixel SP1 includes six transistors T1 to T6 and two capacitors CP1 and CP2, it should be noted that the equivalent circuit diagram of the first sub-pixel SP1 is not limited to that shown in FIG. 3. For example, the number of transistors and the number of capacitors of the first sub-pixel SP1 are not limited to those shown in FIG. 3.

Further, the equivalent circuit diagram of the second sub-pixel SP2 and the equivalent circuit diagram of the third sub-pixel SP3 may each be substantially the same as the equivalent circuit diagram of the first sub-pixel SP1 described in conjunction with FIG. 3. Therefore, the description of the equivalent circuit diagram of the second sub-pixel SP2 and the equivalent circuit diagram of the third sub-pixel SP3 is not repeated in the present disclosure.

FIG. 4 is a layout diagram illustrating an example of a display panel according to one or more embodiments of the present disclosure.

Referring to FIG. 4, the display area DAA of the display panel 100 according to one or more embodiments includes the plurality of pixels PX arranged in a matrix form. The non-display area NDA of the display panel 100 according to one or more embodiments includes the scan driver 610, the emission driver 620, the data driver 700, a first distribution circuit 710, a second distribution circuit 720, the first pad portion PDA1, and a second pad portion PDA2.

The scan driver 610 may be arranged on a first side of the display area DAA, and the emission driver 620 may be arranged on a second side (e.g., opposite the first side) of the display area DAA. For example, in one or more embodiments, the scan driver 610 may be arranged on one side of the display area DAA in the first direction DR1, and the emission driver 620 may be arranged on the other side of the display area DAA in the first direction DR1. For example, the scan driver 610 may be arranged on the left side of the display area DAA, and the emission driver 620 may be arranged on the right side of the display area DAA, as shown in FIG. 4. However, embodiments of the present disclosure are not limited thereto, for example, in one or more embodiments, the scan driver 610 and the emission driver 620 may be arranged on both (e.g., simultaneously) the first side and the second side of the display area DAA.

The first pad portion PDA1 may include the plurality of first pads PD1 connected to pads or bumps of the circuit board 300 through a conductive adhesive member. The first pad portion PDA1 may be arranged on a third side of the display area DAA. For example, in one or more embodiments, the first pad portion PDA1 may be arranged on one side of the display area DAA in the second direction DR2. The first pad portion PDA1 may be arranged outside the data driver 700 in the second direction DR2. For example, the first pad portion PDA1 may be arranged closer to an edge of the display panel 100 than the data driver 700.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board made of a rigid material or a flexible printed circuit board made of a flexible material.

The second pad portion PDA2 may be arranged on a fourth side of the display area DAA. For example, in one or more embodiments, the second pad portion PDA2 may be arranged on the other side of the display area DAA in the second direction DR2. The second pad portion PDA2 may be arranged outside the second distribution circuit 720 in the second direction DR2. For example, the second pad portion PDA2 may be arranged closer to an edge of the display panel 100 than the second distribution circuit 720.

The first distribution circuit 710 distributes data voltages applied through the first pad portion PDA1 to the plurality of data lines DL. For example, in one or more embodiments, the first distribution circuit 710 may distribute the data voltages applied through one first pad PD1 of the first pad portion PDA1 to P (P is a positive integer of 2 or more) data lines DL, and as a result, the number of the plurality of first pads PD1 may be reduced. The first distribution circuit 710 may be arranged on the third side of the display area DAA of the display panel 100. For example, the first distribution circuit 710 may be arranged on one side of the display area DAA in the second direction DR2. For example, the first distribution circuit 710 may be arranged on a lower side of the display area DAA.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be arranged on the fourth side of the display area DAA of the display panel 100. For example, the second distribution circuit 720 may be arranged on the other side of the display area DAA in the second direction DR2. For example, the second distribution circuit 720 may be arranged on an upper side of the display area DAA.

In the context of the present disclosure and unless defined otherwise, "one side of the display area DAA in the second direction DR2" refers to a specific side of the display area along the direction labeled as DR2. For instance, if DR2 represents a vertical direction, this may indicate the bottom side of the display area. Conversely, "the other side of the display area DAA in the second direction DR2" refers to the opposite side of the display area along the same direction DR2, which, continuing the previous example, may indicate the top side of the display area. These phrases are used to describe the positioning of components, such as distribution circuits, on opposite sides of the display area along the specified direction DR2.

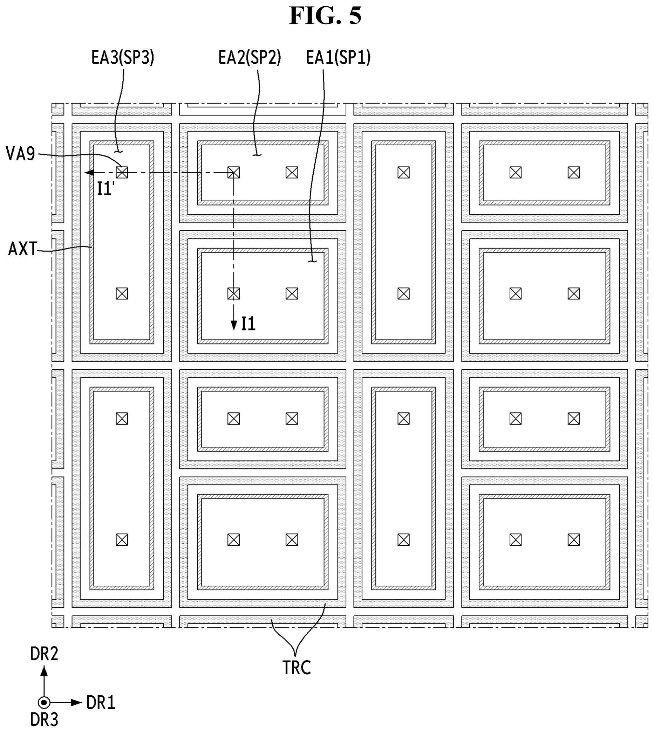

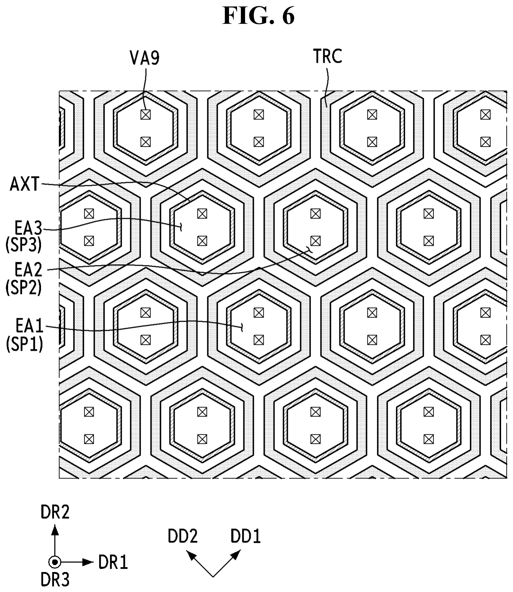

FIG. 5 and FIG. 6 are each a layout diagram illustrating an example of the display area of FIG. 4 according to one or more embodiments.

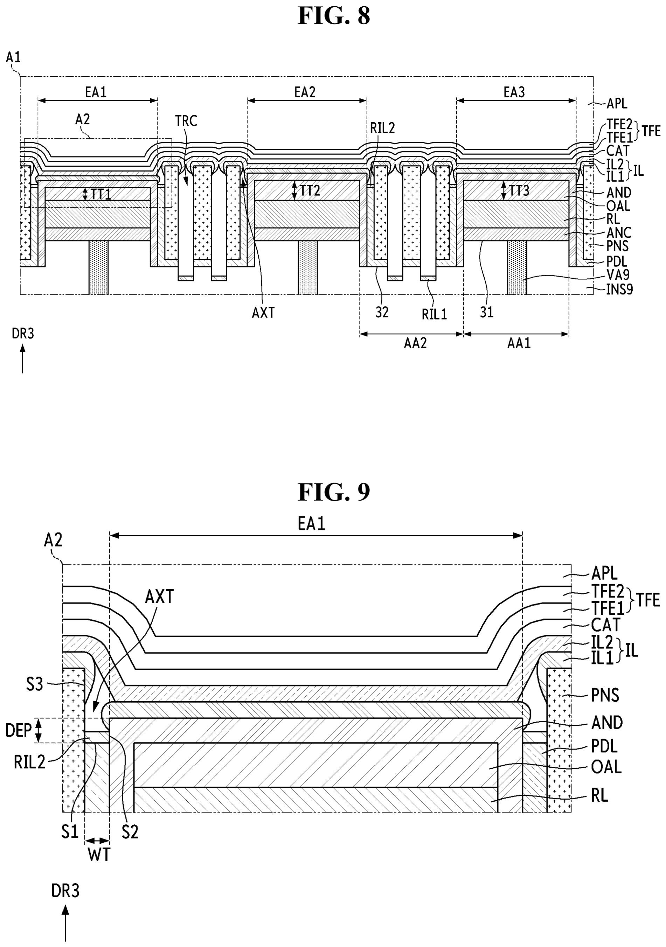

Referring to FIG. 5 and FIG. 6, each of the pixels PX includes a first emission area EA1 that is an emission area of the first sub-pixel SP1, a second emission area EA2 that is an emission area of the second sub-pixel SP2, and a third emission area EA3 that is an emission area of the third sub-pixel SP3. Each of the first emission area EA1, the second emission area EA2, and the third emission area EA3 may be surrounded by an auxiliary trench AXT and a trench TRC, and each of the first emission area EA1, the second emission area EA2, and the third emission area EA3 may include a via VA9. The detailed descriptions of the auxiliary AXT, the trench TRC, and the via VA9 will be described in more detail later with reference to FIG. 7 and FIG. 8.

Each of the first emission area EA1, the second emission area EA2, and the third emission area EA3 may have a polygonal shape, a circular shape, an elliptical shape, or an atypical shape in plan view.

In one or more embodiments, a maximum length of the third emission area EA3 in the first direction DR1 may be less than a maximum length of the second emission area EA2 in the first direction DR1 and a maximum length of the first emission area EA1 in the first direction DR1. The maximum length of the second emission area EA2 in the first direction DR1 and the maximum length of the first emission area EA1 in the first direction DR1 may be substantially the same.

A maximum length of the third emission area EA3 in the second direction DR2 may be greater than a maximum length of the second emission area EA2 in the second direction DR2 and a maximum length of the first emission area EA1 in the second direction DR2. The maximum length of the second emission area EA2 in the second direction DR2 may be less than the maximum length of the first emission area EA1 in the second direction DR2. The maximum length of the third emission area EA3 in the second direction DR2 may be greater than the maximum length of the second emission area EA2 in the second direction DR2.

In one or more embodiments, the first emission area EA1, the second emission area EA2, and the third emission area EA3 may each have, in plan view, a hexagonal shape formed of six straight lines as shown in FIG 6, but embodiments of the present disclosure are not limited thereto. In one or more embodiments, the first emission area EA1, the second emission area EA2, and the third emission area EA3 may each independently have a polygonal shape other than a hexagon, a circular shape, an elliptical shape, or an atypical shape in plan view.

As shown in FIG. 5, in each of the plurality of pixels PX, the first emission area EA1 and the second emission area EA2 may be adjacent to each other in the second direction DR2. Further, the first emission area EA1 and the third emission area EA3 may be adjacent to each other in the first direction DR1. In addition, the second emission area EA2 and the third emission area EA3 may be adjacent to each other in the first direction DR1. The area of the first emission area EA1, the area of the second emission area EA2, and the area of the third emission area EA3 may be different.

In one or more embodiments, as shown in FIG. 6, the third emission area EA3 and the second emission area EA2 may be adjacent to each other in the first direction DR1, but the second emission area EA2 and the first emission area EA1 may be adjacent to each other in a first diagonal direction DD1, and the first emission area EA1 and the third emission area EA3 may be adjacent to each other in a second diagonal direction DD2. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction normal (e.g., perpendicular) to the first diagonal direction DD1.

The first sub-pixel SP1 may be to emit first light that has passed through a first color filter CF1 (see FIG. 7) among lights emitted from the first emission area EA1, the second sub-pixel SP2 may be to emit second light that has passed through a second color filter CF2 (see FIG. 7) among lights emitted from the second emission area EA2, and the third sub-pixel SP3 may be to emit third light that has passed through a third color filter CF3 (see FIG. 7) among lights emitted from the third emission area EA3. In one or more embodiments, the first light may be light of a red wavelength band, the second light may be light of a green wavelength band, and the third light may be light of a blue wavelength band. For example, the red wavelength band may be a wavelength band of light whose main peak wavelength is in the range of approximately (about) 600 nm to (about) 750 nm, the green wavelength band may be a wavelength band of light whose main peak wavelength is in the range of approximately (about) 480 nm to (about) 560 nm, and the blue wavelength band may be a wavelength band of light whose main peak wavelength is in the range of approximately (about) 370 nm to (about) 460 nm.

It is an example in FIG. 5 and FIG. 6 that each of the plurality of pixels PX includes three emission areas EA1, EA2, and EA3, but embodiments of the present disclosure are not limited thereto. For example, in one or more embodiments, each of the plurality of pixels PX may include four emission areas.

In addition, the layout of the emission areas of the plurality of pixels PX is not limited to those illustrated in FIG. 5 and FIG. 6. For example, in one or more embodiments, the emission areas of the plurality of pixels PX may be arranged in a stripe structure in which the emission areas are arranged in the first direction DR1, a PenTile^{®} structure in which the emission areas are arranged in a diamond shape, or a hexagonal structure in which the emission areas having, in plan view, a hexagonal shape are arranged as shown in FIG. 6. PenTile^{®} is a duly registered trademark of Samsung Display Co., Ltd.

FIG. 7 is a cross-sectional view illustrating an example of a display panel taken along the line I1-I1' of FIG. 5 according to one or more embodiments. FIG. 8 is a cross-sectional view showing area A1 of FIG. 7 in more detail according to one or more embodiments.

Referring to FIG. 7 and FIG. 8, the display panel 100 includes a semiconductor backplane SBP, a light emitting element backplane EBP, a display element layer EML, an encapsulation layer TFE, an optical layer OPL, a cover layer CVL, and a polarizing plate POL.

The semiconductor backplane SBP includes the semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively. The plurality of pixel transistors PTR may include (e.g., be) the first to sixth transistors T1 to T6 described with reference to FIG. 3.

The semiconductor substrate SSUB may be a silicon substrate, a germanium substrate, or a silicon-germanium substrate. The semiconductor substrate SSUB may be a substrate doped with a first type (kind) impurity. A plurality of well regions WA may be arranged on a top surface of the semiconductor substrate SSUB. The plurality of well regions WA may be regions doped with a second type (kind) impurity. The second type (kind) impurity may be different from the aforementioned first type (kind) impurity. For example, in one or more embodiments, if (e.g., when) the first type (kind) impurity is a p-type (kind) impurity, the second type (kind) impurity may be an n-type (kind) impurity. In one or more embodiments, if (e.g., when) the first type (kind) impurity is an n-type (kind) impurity, the second type (kind) impurity may be a p-type (kind) impurity.

Each of the plurality of well regions WA includes a source region SA corresponding to the source electrode of the pixel transistor PTR, a drain region DA corresponding to the drain electrode thereof, and a channel region CH arranged between the source region SA and the drain region DA.

A lower insulating layer BINS may be arranged between a gate electrode GE and the well region WA. A side insulating layer SINS may be arranged on a side surface of the gate electrode GE. The side insulating layer SINS may be arranged on the lower insulating layer BINS.

Each of the source region SA and the drain region DA may be a region doped with the first type (kind) impurity. The gate electrode GE of the pixel transistor PTR may overlap the well region WA in the third direction DR3, which is the thickness direction of the semiconductor substrate SSUB. The channel region CH may overlap the gate electrode GE in the third direction DR3. The source region SA may be arranged on one side of the gate electrode GE, and the drain region DA may be arranged on the other side of the gate electrode GE.

Each of the plurality of well regions WA may further include a first low-concentration impurity region LDD1 arranged between the channel region CH and the source region SA, and a second low-concentration impurity region LDD2 arranged between the channel region CH and the drain region DA. The first low-concentration impurity region LDD1 may be a region having a lower impurity concentration than the source region SA due to the lower insulating layer BINS. The second low-concentration impurity region LDD2 may be a region having a lower impurity concentration than the drain region DA due to the lower insulating layer BINS. The distance between the source region SA and the drain region DA may increase due to the presence of the first low-concentration impurity region LDD1 and the second low-concentration impurity region LDD2. Therefore, the length of the channel region CH of each of the pixel transistors PTR may increase, so that punch-through and hot carrier phenomena that might be caused by a short channel may be reduced or prevented.

A first semiconductor insulating layer SINS1 may be arranged on the semiconductor substrate SSUB. In one or more embodiments, the first semiconductor insulating layer SINS1 may be formed of a silicon carbonitride (SiCN)-based inorganic film or a silicon oxide (SiOₓ)-based inorganic film, but embodiments of the present disclosure are not limited thereto.

A second semiconductor insulating layer SINS2 may be arranged on the first semiconductor insulating layer SINS1. In one or more embodiments, the second semiconductor insulating layer SINS2 may be formed of a silicon oxide (SiOₓ)-based inorganic film, but embodiments of the present disclosure are not limited thereto.

The plurality of contact terminals CTE may be arranged on the second semiconductor insulating layer SINS2. Each of the plurality of contact terminals CTE may be connected to any one of the gate electrode GE, the source region SA, and the drain region DA of each of the pixel transistors PTR through holes penetrating the first semiconductor insulating layer SINS1 and the second semiconductor insulating layer SINS2. The plurality of contact terminals CTE may each be formed of any one selected from among copper (Cu), aluminum (Al), tungsten (W), molybdenum (Mo), chromium (Cr), gold (Au), titanium (Ti), nickel (Ni), and neodymium (Nd), or an alloy or a compound including any one of them.

A third semiconductor insulating layer SINS3 may be arranged on a side surface of each of the plurality of contact terminals CTE. A top surface of each of the plurality of contact terminals CTE may be exposed without being covered by the third semiconductor insulating layer SINS3. In one or more embodiments, the third semiconductor insulating layer SINS3 may be formed of a silicon oxide (SiOₓ)-based inorganic film, but embodiments of the present disclosure are not limited thereto.

In one or more embodiments, the semiconductor substrate SSUB may be replaced with a glass substrate or a polymer resin substrate such as polyimide. In these embodiments, thin film transistors may be arranged on the glass substrate or the polymer resin substrate. The glass substrate may be a rigid substrate that does not bend, and the polymer resin substrate may be a flexible substrate that can be bent or curved.

The light emitting element backplane EBP may include a plurality of conductive layers ML1 to ML8, a plurality of vias VA1 to VA9, and a plurality of insulating layers INS1 to INS9. In addition, the light emitting element backplane EBP includes a plurality of insulating layers INS1 to INS9 arranged between the first to eighth conductive layers ML1 to ML8.

The first to eighth conductive layers ML1 to ML8 serve to connect the plurality of contact terminals CTE exposed from the semiconductor backplane SBP to thereby implement the circuit of the first sub-pixel SP1 shown in FIG. 3. For example, in one or more embodiments, the first to sixth transistors T1 to T6 are merely formed in the semiconductor backplane SBP, and the connection of the first to sixth transistors T1 to T6 and the first and second capacitors CP1 and CP2 is accomplished through the first to eighth conductive layers ML1 to ML8. In addition, the connection between the drain region corresponding to the drain electrode of the fourth transistor T4, the source region corresponding to the source electrode of the fifth transistor T5, and a first electrode AND of the light emitting element LE is also accomplished through the first to eighth conductive layers ML1 to ML8.

A first insulating layer INS1 may be arranged on the semiconductor backplane SBP. Each of first vias VA1 may penetrate the first insulating layer INS1 to be connected to the contact terminal CTE exposed from the semiconductor backplane SBP. Each of first conductive layers ML1 may be arranged on the first insulating layer INS1 and may be connected to the first via VA1.

A second insulating layer INS2 may be arranged on the first insulating layer INS1 and the first conductive layers ML1. Each of second vias VA2 may penetrate the second insulating layer INS2 and be connected to the exposed first conductive layer ML1. Each of second conductive layers ML2 may be arranged on the second insulating layer INS2 and may be connected to the second via VA2.

A third insulating layer INS3 may be arranged on the second insulating layer INS2 and the second conductive layers ML2. Each of third vias VA3 may penetrate the third insulating layer INS3 and be connected to the exposed second conductive layer ML2. Each of third conductive layers ML3 may be arranged on the third insulating layer INS3 and may be connected to the third via VA3.

A fourth insulating layer INS4 may be arranged on the third insulating layer INS3 and the third conductive layers ML3. Each of fourth vias VA4 may penetrate the fourth insulating layer INS4 and be connected to the exposed third conductive layer ML3. Each of fourth conductive layers ML4 may be arranged on the fourth insulating layer INS4 and may be connected to the fourth via VA4.

A fifth insulating layer INS5 may be arranged on the fourth insulating layer INS4 and the fourth conductive layers ML4. Each of fifth vias VA5 may penetrate the fifth insulating layer INS5 and be connected to the exposed fourth conductive layer ML4. Each of fifth conductive layers ML5 may be arranged on the fifth insulating layer INS5 and may be connected to the fifth via VA5.

A sixth insulating layer INS6 may be arranged on the fifth insulating layer INS5 and the fifth conductive layers ML5. Each of sixth vias VA6 may penetrate the sixth insulating layer INS6 and be connected to the exposed fifth conductive layer ML5. Each of sixth conductive layers ML6 may be arranged on the sixth insulating layer INS6 and may be connected to the sixth via VA6.

A seventh insulating layer INS7 may be arranged on the sixth insulating layer INS6 and the sixth conductive layers ML6. Each of seventh vias VA7 may penetrate the seventh insulating layer INS7 and be connected to the exposed sixth conductive layer ML6. Each of seventh conductive layers ML7 may be arranged on the seventh insulating layer INS7 and may be connected to the seventh via VA7.

An eighth insulating layer INS8 may be arranged on the seventh insulating layer INS7 and the seventh conductive layers ML7. Each of eighth vias VA8 may penetrate the eighth insulating layer INS8 and be connected to the exposed seventh conductive layer ML7. Each of eighth conductive layers ML8 may be arranged on the eighth insulating layer INS8 and may be connected to the eighth via VA8.

The first to eighth conductive layers ML1 to ML8 and the first to eighth vias VA1 to VA8 may be formed of substantially a same material. In one or more embodiments, the first to eighth conductive layers ML1 to ML8 and the first to eighth vias VA1 to VA8 may each be formed of any one selected from among copper (Cu), aluminum (Al), tungsten (W), molybdenum (Mo), chromium (Cr), gold (Au), titanium (Ti), nickel (Ni), and neodymium (Nd), or an alloy or a compound including any one of them. The first to eighth vias VA1 to VA8 may be made of substantially the same material. First to eighth insulating layers INS1 to INS8 may be formed of a silicon oxide (SiOₓ)-based inorganic film, but embodiments of the present disclosure are not limited thereto.

The thicknesses of the first conductive layer ML1, the second conductive layer ML2, the third conductive layer ML3, the fourth conductive layer ML4, the fifth conductive layer ML5, and the sixth conductive layer ML6 may be greater than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, in one or more embodiments, the thickness of the first conductive layer ML1 may be approximately (about) 1360 angstroms (Å) (i.e., 10⁻¹⁰ m). The thickness of each of the second conductive layer ML2, the third conductive layer ML3, the fourth conductive layer ML4, the fifth conductive layer ML5, and the sixth conductive layer ML6 may be approximately (about) 1440 Å. The thickness of each of the first via VA1, the second via VA2, the third via VA3, the fourth via VA4, the fifth via VA5, and the sixth via VA6 may be approximately (about) 1150 Å.

The thickness of each of the seventh conductive layer ML7 and the eighth conductive layer ML8 may be greater than the thickness of each of the first conductive layer ML1, the second conductive layer ML2, the third conductive layer ML3, the fourth conductive layer ML4, the fifth conductive layer ML5, and the sixth conductive layer ML6. The thickness of the seventh conductive layer ML7 and the thickness of the eighth conductive layer ML8 may be greater than the thickness of the seventh via VA7 and the thickness of the eighth via VA8, respectively. The thickness of each of the seventh via VA7 and the eighth via VA8 may be greater than the thickness of each of the first via VA1, the second via VA2, the third via VA3, the fourth via VA4, the fifth via VA5, and the sixth via VA6. The thickness of the seventh conductive layer ML7 and the thickness of the eighth conductive layer ML8 may be substantially the same. For example, in one or more embodiments, the thickness of each of the seventh conductive layer ML7 and the eighth conductive layer ML8 may be approximately (about) 9,000 Å. The thickness of each of the seventh via VA7 and the eighth via VA8 may be approximately (about) 6,000 Å.

A ninth insulating layer INS9 may be arranged on the eighth insulating layer INS8 and the eighth conductive layer ML8. The ninth insulating layer INS9 may have an uneven shape, as shown in FIG. 8. For example, the ninth insulating layer INS9 may have a protrusion 31 protruding in a first region AA1 toward a light emitting stack IL (or in the third direction DR3), and a groove 32 recessed in a second region AA2 toward the semiconductor substrate SSUB (or in a reverse direction to the third direction DR3 (hereinafter, referred to as a third reverse direction)). The first region AA1 and the second region AA2 may be alternately arranged. For example, the protrusions 31 and the grooves 32 of the ninth insulating layer INS9 may be alternately arranged along the first direction DR1 or the second direction DR2. The thicknesses of the protrusions 31 of the ninth insulating layer INS9 may be the same, and the depths of the grooves 32 of the ninth insulating layer INS9 may be the same. Here, the thickness and the depth may be the sizes/lengths in the third direction DR3. In one or more embodiments, the ninth insulating layer INS9 may be formed of a silicon oxide (SiOₓ)-based inorganic film, but embodiments of the present disclosure are not limited thereto.

Each of ninth vias VA9 may penetrate the ninth insulating layer INS9 and be connected to the exposed eighth conductive layer ML8. The ninth vias VA9 may be formed of any one selected from among copper (Cu), aluminum (Al), tungsten (W), molybdenum (Mo), chromium (Cr), gold (Au), titanium (Ti), nickel (Ni), and neodymium (Nd), or an alloy or a compound including any one of them. In one or more embodiments, the thickness of the ninth via VA9 may be approximately (about) 16,500 Å.

The display element layer EML may be arranged on the light emitting element backplane EBP. The display element layer EML may include a plurality of connection electrodes ANC, a plurality of reflective electrodes RL, a plurality of optical auxiliary layers OAL, a planarization layer PNS, a pixel defining layer PDL, a plurality of first electrodes AND, the light emitting stack IL, a second electrode CAT, and a plurality of trenches TRC.

Further, the display element layer EML may include the first emission area EA1, the second emission area EA2, and the third emission area EA3. Each of the first emission area EA1, the second emission area EA2, and the third emission area EA3 may be an area where the first electrode AND, the light emitting stack IL, and the second electrode CAT are sequentially stacked. Each of the first emission area EA1, the second emission area EA2, and the third emission area EA3 may be an area where the light emitting element LE including the first electrode AND, the light emitting stack IL, and the second electrode CAT is arranged. Each of the first emission area EA1, the second emission area EA2, and the third emission area EA3 may be partitioned by the pixel defining layer PDL.

The ninth insulating layer INS9 may include the first regions AA1 overlapping the plurality of connection electrodes ANC and the second region AA2 arranged around each of the first regions AA1. The thickness of the first region AA1 of the ninth insulating layer INS9 may be greater than the thickness of the second region AA2 of the ninth insulating layer INS9.

The plurality of connection electrodes ANC may be respectively arranged on the first regions AA1 of the ninth insulating layer INS9. Each of the plurality of connection electrodes ANC may be arranged on the corresponding first region AA1. For example, each of the plurality connection electrodes ANC may be arranged on the protrusion 31 of the corresponding first region AA1. In one or more embodiments, the plurality of connection electrodes ANC may be formed of titanium nitride (TiN) or a transparent conductive oxide. For example, the transparent conductive oxide may be indium tin oxide (ITO) or indium zinc oxide (IZO), but embodiments of the present disclosure are not limited thereto.

The connection electrode ANC of the first sub-pixel SP1, the connection electrode ANC of the second sub-pixel SP2, and the connection electrode ANC of the third sub-pixel SP3 may have a same thickness. Here, the thickness may be the size/length in the third direction DR3.

In each of the first sub-pixels SP1, the reflective electrode RL may be arranged on the connection electrode ANC. For example, in each of the first sub-pixels SP1, the reflective electrode RL may cover a top surface of the connection electrode ANC.

In each of the second sub-pixels SP2, the reflective electrode RL may be arranged on the connection electrode ANC. For example, in each of the second sub-pixels SP2, the reflective electrode RL may cover a top surface of the connection electrode ANC.

In each of the third sub-pixels SP3, the reflective electrode RL may be arranged on the connection electrode ANC. For example, in each of the third sub-pixels SP3, the reflective electrode RL may cover a top surface of the connection electrode ANC.

The reflective electrode RL of the first sub-pixel SP1, the reflective electrode RL of the second sub-pixel SP2, and the reflective electrode RL of the third sub-pixel SP3 may have a same thickness. Here, the thickness may be the size/length in the third direction.

Each of the reflective electrodes RL may be formed of any one selected from among copper (Cu), aluminum (Al), tungsten (W), molybdenum (Mo), chromium (Cr), gold (Au), titanium (Ti), nickel (Ni), and neodymium (Nd), or an alloy or a compound including any one of them. For example, in one or more embodiments, each of the reflective electrodes RL may include aluminum (Al) with high reflectivity.

The optical auxiliary layers OAL may be respectively arranged on the reflective electrodes RL. On each of the reflective electrodes RL, the corresponding optical auxiliary layer OAL may be arranged. In one or more embodiments, the optical auxiliary layer OAL may be formed of a silicon oxide (SiOₓ)-based inorganic film, but embodiments of the present disclosure are not limited thereto.

A thickness TT1 of the optical auxiliary layer OAL in the first sub-pixel SP1, a thickness TT2 of the optical auxiliary layer OAL in the second sub-pixel SP2, and a thickness TT3 of the optical auxiliary layer OAL in the third sub-pixel SP3 may be different from one another. For example, in one or more embodiments, the thickness TT1 of the optical auxiliary layer OAL in the first sub-pixel SP1 may be the smallest. Further, the thickness TT2 of the optical auxiliary layer OAL in the second sub-pixel SP2 may be greater than the thickness TT1 of the optical auxiliary layer OAL in the first sub-pixel SP1. The thickness TT3 of the optical auxiliary layer OAL in the third sub-pixel SP3 may be the same as the thickness TT2 of the optical auxiliary layer OAL in the second sub-pixel SP2.

The thickness TT1 of the optical auxiliary layer OAL in the first sub-pixel SP1, the thickness TT2 of the optical auxiliary layer OAL in the second sub-pixel SP2, and the thickness TT3 of the optical auxiliary layer OAL in the third sub-pixel SP3 may be set in consideration of the main peak wavelength of the first light, the main peak wavelength of the second light, the main peak wavelength of the third light, the distance from a first stack layer IL1 to the reflective electrode RL in the first emission area EA1, and the distance from a second stack layer IL2 to the reflective electrode RL in the second emission area EA2, and accordingly, the resonance distance of the first light, the resonance distance of the second light, and the resonance distance of the third light may be set.

Each of the light emitting elements LE may include the first electrode AND, the light emitting stack IL, and the second electrode CAT.

The first electrode AND of each of the light emitting elements LE may be arranged on a side surface of the connection electrode ANC, a side surface of the reflective electrode RL, and a top surface and a side surface of the optical auxiliary layer OAL. For example, the first electrode AND of each of the light emitting elements LE may be around (e.g., surround) the optical auxiliary layer OAL, the reflective electrode RL, and the connection electrode ANC together with the ninth insulating layer INS9. Because the first electrode AND of each of the light emitting elements LE is in contact with and electrically connected to the side surface of the reflective electrode RL and the side surface of the connection electrode ANC, the number of mask processes may be reduced compared to if (e.g., when) the first electrode AND of each of the light emitting elements LE is connected to the reflective electrode RL exposed through a through hole penetrating the optical auxiliary layer OAL, which makes it possible to reduce the fabrication cost and increase the fabrication efficiency.

Further, because the thickness of the first region AA1 of the ninth insulating layer INS9 is greater than the thickness of the second region AA2, a part of the ninth insulating layer INS9 may be exposed in the first region AA1. Therefore, the first electrode AND of each of the light emitting elements LE may be arranged on a part of the ninth insulating layer INS9 in the first region AA1. Therefore, the length of the first electrode AND in the third direction DR3 may be greater than the sum of the length of the side surface of the connection electrode ANC, the length of the side surface of the reflective electrode RL, and the length of the side surface of the optical auxiliary layer OAL.

The first electrode AND of each of the light emitting elements LE may be connected to the drain region DA or the source region SA of the pixel transistor PTR through the connection electrode ANC, the first to ninth vias VA1 to VA9, the first to eighth conductive layers ML1 to ML8, and the contact terminal CTE.

The first electrode AND of each of the light emitting elements LE may be formed of any one selected from among copper (Cu), aluminum (Al), tungsten (W), molybdenum (Mo), chromium (Cr), gold (Au), titanium (Ti), nickel (Ni), and neodymium (Nd), or an alloy or a compound including any one of them. For example, in one or more embodiments, the first electrode AND of each of the light emitting elements LE may be titanium nitride (TiN).

The thickness of the first electrode AND arranged on the top surface of the optical auxiliary layer OAL may be less than the thickness of the first electrode AND arranged on the side surface of the connection electrode ANC, the side surface of the reflective electrode RL, and the side surface of the optical auxiliary layer OAL. For example, in one or more embodiments, the first electrode AND arranged on the top surface of the optical auxiliary layer OAL is formed to have a thickness of approximately (about) 50 Å or less, so that the light transmittance of the first electrode AND arranged on the top surface of the optical auxiliary layer OAL may be improved. In addition, the first electrode AND arranged on the side surface of the connection electrode ANC, the side surface of the reflective electrode RL, and the side surface of the optical auxiliary layer OAL may be formed to have a thickness of about 100 Å to about 200 Å. Thus, an increase in contact resistance that might occur as a result of the first electrode AND being in contact with only the side surface of the connection electrode ANC and the side surface of the reflective electrode RL may be minimized or reduced.

The pixel defining layer PDL may be arranged on the ninth insulating layer INS9 to be around (e.g., surround) a side surface of the first electrode AND of each of the light emitting elements LE. For example, in plan view, the pixel defining layer PDL may be arranged in the groove 32 of the second region AA2 of the ninth insulating layer INS9 so as to be around (e.g., surround) the first electrode AND of each of the light emitting elements LE. The pixel defining layer PDL may partition the first emission areas EA1, the second emission areas EA2, and the third emission areas EA3. In cross-sectional view, the pixel defining layer PDL may have a U-shape.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The planarization layer PNS may be a film for flattening steps between the sub-pixels SP1, SP2, and SP3 caused by the optical auxiliary layer OAL. The planarization layer PNS may be arranged in the second region AA2 of the ninth insulating layer INS9, for example, on the groove 32. The planarization layer PNS may be enclosed by the pixel defining layer PDL in the groove 32. The planarization layer PNS may be arranged between the connection electrodes ANC adjacent in the first direction DR1 or the second direction DR2. The planarization layer PNS may be arranged between the reflective electrodes RL adjacent in the first direction DR1 or the second direction DR2. The planarization layer PNS may be arranged between the optical auxiliary layers OAL adjacent in the first direction DR1 or the second direction DR2. The planarization layer PNS may be arranged on the pixel defining layer PDL arranged in the second region AA2 of the ninth insulating layer INS9. The pixel defining layer PDL is formed of a material different from that of the planarization layer PNS, and thus may serve as a stopper in a chemical mechanical polishing process for the planarization layer PNS.

Each of the plurality of trenches TRC may penetrate the pixel defining layer PDL and the planarization layer PNS. Further, the ninth insulating layer INS9 may be partially recessed at each of the plurality of trenches TRC.

At least one trench TRC may be arranged between adjacent emission areas EA1, EA2, and EA3. Although FIG. 7 and FIG. 8 illustrate that two trenches TRC are arranged between neighboring emission areas EA1, EA2, and EA3, embodiments of the present disclosure are not limited thereto.

The light emitting stack IL may include a plurality of stack layers IL1 and IL2. FIG. 7 and FIG. 8 illustrate that the light emitting stack IL has a two-tandem structure including a first stack layer IL1 and a second stack layer IL2, but embodiments of the present disclosure are not limited thereto. For example, in one or more embodiments, the light emitting stack IL may have a three-tandem structure including three stack layers.

In the two-tandem structure, in one or more embodiments, the light emitting stack IL may have a tandem structure including a plurality of stack layers IL1 and IL2 that emit different lights. For example, the light emitting stack IL may include the first stack layer IL1 that is configured to emit first light and the second stack layer IL2 that is configured to emit fourth light. The first stack layer IL1 and the second stack layer IL2 may be stacked sequentially (e.g., in the stated order). Here, the first light may be red light, and the fourth light may be green light.

The first stack layer IL1 may have a structure in which a first hole transport layer, a first organic light emitting layer that emits the first light, and a first electron transport layer are sequentially stacked (e.g., in the stated order). The second stack layer IL2 may have a structure in which a second hole transport layer, a second organic light emitting layer that emits the fourth light, and a second electron transport layer are sequentially stacked (e.g., in the stated order).

In one or more embodiments, a charge generation layer for supplying charges (e.g., holes) to the second stack layer IL2 and supplying electrons to the first stack layer IL1 may be arranged between the first stack layer IL1 and the second stack layer IL2. The charge generation layer may include an n-type (kind) charge generation layer that supplies electrons to the first stack layer IL1 and a p-type (kind) charge generation layer that supplies holes to the second stack layer IL2. The n-type (kind) charge generation layer may include a dopant of a metal material.

The first stack layer IL1 may be arranged on the first electrodes AND and the planarization layer PNS. A residual film RIL1 made of a same material as the first stack layer IL1 may be arranged on a bottom surface of each of the trenches TRC. Due to the trench TRC, the first stack layer IL1 may be cut off between the neighboring sub-pixels SP1, SP2, and SP3. A cavity or an empty space may be arranged between the residual film RIL1 and the first stack layer IL1 in each trench TRC. The second stack layer IL2 may be arranged on the first stack layer IL1. The second stack layer IL2 is not cut off by the trench TRC and may be arranged to cover the first stack layer IL1 in each of the trenches TRC.

Thus, in a two-tandem structure, an electric current (e.g., a lateral current leakage) may flow through a charge generation layer of the display element layer EML between the neighboring sub-pixels SP1, SP2, and SP3. Each of the plurality of trenches TRC may be a structure for cutting off the charge generation layer to prevent or reduce such a lateral current leakage.

In order to stably cut off the charge generation layer of the display element layer EML between the neighboring emission areas EA1, EA2, and EA3, the height of each of the plurality of trenches TRC may be greater than the height of the pixel defining layer PDL and the height of the planarization layer PNS. The height of each of the plurality of trenches TRC refers to a length of each of the plurality of trenches TRC in the third direction DR3. The height of the pixel defining layer PDL refers to a length of the pixel defining layer PDL in the third direction DR3. The height of the planarization layer PNS refers to a length of the planarization layer PNS in the third direction DR3.

In order to cut off the charge generation layer of the display element layer EML between the adjacent emission areas EA1, EA2, and EA3, another structure may be used instead of the trench TRC. For example, in one or more embodiments, instead of the trench TRC, a reverse tapered partition wall may be arranged on the pixel defining layer PDL.

The second electrode CAT may be arranged on the light emitting stack IL. The second electrode CAT may be arranged on the second stack layer IL2 on each of the plurality of trenches TRC. In one or more embodiments, the second electrode CAT may be formed of a transparent conductive material (TCO), or a semi-transmissive conductive material such as magnesium (Mg), silver (Ag), or an alloy of magnesium (Mg) and silver (Ag). In this regards, light emission efficiency in each of the first to third sub-pixels SP1, SP2, and SP3 may be increased due to a micro-cavity effect.

The encapsulation layer TFE may be arranged on the display element layer EML. The encapsulation layer TFE may include at least one of an inorganic film TFE1 or an inorganic film TFE2 to reduce or prevent oxygen and/or moisture from permeating into the display element layer EML. For example, in one or more embodiments, the encapsulation layer TFE may include a first encapsulation inorganic layer TFE1 and a second encapsulation inorganic layer TFE2.

The first encapsulation inorganic layer TFE1 may be arranged on the second electrode CAT. The first encapsulation inorganic layer TFE1 may be formed as a multilayer in which one or more inorganic films selected from among silicon nitride (SiNₓ), silicon oxy nitride (SiON), and silicon oxide (SiOₓ) are alternately stacked. The first encapsulation inorganic layer TFE1 may be formed by a chemical vapor deposition (CVD) process.

The second encapsulation inorganic layer TFE2 may be arranged on the first encapsulation inorganic layer TFE1. The second encapsulation inorganic layer TFE2 may be formed of titanium oxide (TiOₓ) or aluminum oxide (AlOₓ), but embodiments of the present disclosure are not limited thereto. The second encapsulation inorganic layer TFE2 may be formed by an atomic layer deposition (ALD) process. The thickness of the second encapsulation inorganic layer TFE2 may be less than the thickness of the first encapsulation inorganic layer TFE1.

An organic layer APL may be a layer for increasing the interfacial adhesion between the encapsulation layer TFE and the optical layer OPL. The organic layer APL may be an organic film such as formed of an acrylic resin, an epoxy resin, a phenolic resin, a polyamide resin, or a polyimide resin.

The optical layer OPL includes a plurality of color filters CF1, CF2, and CF3, a plurality of lenses LNS, and a filling layer FIL. The plurality of color filters CF1, CF2, and CF3 may include first to third color filters CF1, CF2, and CF3. The first to third color filters CF1, CF2, and CF3 may be arranged on the organic layer APL.

The first color filter CF1 may overlap the first emission area EA1 of the first sub-pixel SP1. The first color filter CF1 may be to transmit the first light, i.e., light of a red wavelength band. Thus, the first color filter CF1 may be to transmit the first light among light emitted from the light emitting stack IL of the first emission area EA1.

The second color filter CF2 may overlap the second emission area EA2 of the second sub-pixel SP2. The second color filter CF2 may be to transmit the second light, i.e., light of a green wavelength band. Thus, the second color filter CF2 may be to transmit the second light among light emitted from the light emitting stack IL of the second emission area EA2.

The third color filter CF3 may overlap the third emission area EA3 of the third sub-pixel SP3. The third color filter CF3 may be to transmit the third light, i.e., light of a blue wavelength band. Thus, the third color filter CF3 may be to transmit the third light among light emitted from the light emitting stack IL of the third emission area EA3.

The plurality of lenses LNS may be arranged on the first color filter CF1, the second color filter CF2, and the third color filter CF3, respectively. Each of the plurality of lenses LNS may be a structure for increasing the proportion of light directed to the front of the display device 10. Although each of the lenses LNS is illustrated as having a cross-sectional shape that is convex upward, embodiments of the present disclosure are not limited thereto.

The filling layer FIL may be arranged on the plurality of lenses LNS. The filling layer FIL may have a set or predetermined refractive index such that light travels in the third direction DR3 at an interface between the filling layer FIL and the plurality of lenses LNS. Further, the filling layer FIL may also be a planarization layer. The filling layer FIL may be an organic film such as formed of an acrylic resin, an epoxy resin, a phenolic resin, a polyamide resin, or a polyimide resin.

The cover layer CVL may be arranged on the filling layer FIL. The cover layer CVL may be a glass substrate or a polymer resin. In one or more embodiments, when the cover layer CVL is a glass substrate, it may be attached onto the filling layer FIL. In these embodiments, the filling layer FIL may serve to bond the cover layer CVL. When the cover layer CVL is a glass substrate, it may serve as an encapsulation substrate. In one or more embodiments, when the cover layer CVL is a polymer resin, it may be directly applied onto the filling layer FIL.

The polarizing plate POL may be arranged on a (e.g., one) surface of the cover layer CVL. The polarizing plate POL may be a structure for reducing or preventing visibility degradation caused by reflection of external light. The polarizing plate POL may include a linear polarizing plate and a phase retardation film. For example, in one or more embodiments, the phase retardation film may be a λ/4 plate (quarter-wave plate), but embodiments of the present disclosure are not limited thereto. However, if (e.g., when) visibility degradation caused by reflection of external light is sufficiently overcome by the first to third color filters CF1, CF2, and CF3, the polarizing plate POL may not be provided.

In addition to the above-described trench TRC, according to one or more embodiments of the present disclosure, an auxiliary trench AXT may be arranged around the first electrode AND. This will be described in more detail with reference to FIG. 9.

FIG. 9 is an enlarged view of area A2 of FIG. 8 according to one or more embodiments of the present disclosure.

As shown in FIG. 9, the auxiliary trench AXT may be arranged in the second region AA2 of the ninth insulating layer INS9, for example, on the groove 32.

As illustrated in FIG. 5, in plan view, the auxiliary trench AXT may be arranged to be around (e.g., surround) the first electrode AND.

The auxiliary trench AXT may be defined by the first electrode AND, the pixel defining layer PDL, and the planarization layer PNS arranged adjacent to each other. For example, the pixel defining layer PDL may define a bottom surface of the auxiliary trench AXT, and the first electrode AND and the planarization layer PNS may define side surfaces of the auxiliary trench AXT. For example, a top surface S1 (or uppermost surface) of the pixel defining layer PDL may define the bottom surface of the auxiliary trench AXT, and a side surface S2 of the first electrode AND and a side surface S3 of the planarization layer PNS may define the side surfaces of the auxiliary trench AXT. Here, the top surface S1 of the pixel defining layer PDL may be arranged at a height lower than those of the top surface of the first electrode AND and the top surface of the planarization layer PNS. In this regard, if (e.g., when) a bottom surface of the groove 32 is defined as a reference surface (e.g., reference plane), the aforementioned height may be a distance from the reference plane to the top surface of the component concerned in the third direction DR3.

A residual film RIL2 made of a same material as the first stack layer IL1 may be arranged on the bottom surface of the auxiliary trench AXT in each of the auxiliary trenches AXT.

Due to the auxiliary trench AXT, the first stack layer IL1 may be cut off between the neighboring sub-pixels SP1, SP2, and SP3. A cavity or an empty space may be arranged between the residual film RIL2 and the first stack layer IL1 in each auxiliary trench AXT. The second stack layer IL2 may be arranged on the first stack layer IL1. The second stack layer IL2 is not cut off by the auxiliary trench AXT and may be arranged to cover the first stack layer IL1 in each of the auxiliary trenches AXT.

In the two-tandem structure, the light emitting stack layer IL arranged at the edge of each of the sub-pixels SP1, SP2, and SP3 (for example, at the edge of each of the first electrodes AND) may have a curved shape due to the step between the sub-pixels SP1, SP2, and SP3, so that the distance between the hole injection layer and the charge generation layer at the edge of each of the sub-pixels SP1, SP2, and SP3) (for example, at the edge of each of the first electrodes AND) may be shortened. Accordingly, a strong electric field may be generated between the hole injection layer and the charge generation layer at the edge of each first electrode AND, and a current leakage (for example, a vertical current leakage) may be generated at the edge of each first electrode AND by the electric field. The auxiliary trench AXT described above may prevent or reduce such a vertical current leakage by disconnecting the first stack layer IL1 (e.g., the hole injection layer of the first stack layer IL1) and the charge generation layer at the edge of each first electrode AND. Accordingly, the image quality of the display device 10 may be improved.

A depth DEP of the auxiliary trench AXT may be smaller than a depth of the aforementioned trench TRC. A width WT of the auxiliary trench AXT may be smaller than a width of the aforementioned trench TRC. In one or more embodiments, the depth DEP of the auxiliary trench AXT may be about 200 Å, and the width WT of the auxiliary trench AXT may be about 500 Å to about 1000 Å. Here, the depth DEP of the auxiliary trench AXT may be defined as a distance in the third direction DR3 from the bottom surface S1 of the auxiliary trench AXT to the top surface of the first electrode AND, and the width WT of the auxiliary trench AXT may be defined as a distance between the first electrode AND and the planarization layer PNS adjacent thereto. For example, the width WT of the auxiliary trench AXT may be a distance between the side surface S2 of the first electrode AND and the side surface S1 of the planarization layer PNS adjacent thereto. For example, the depth DEP of the auxiliary trench AXT is smaller than the depth of the main trench TRC, and the width WT of the auxiliary trench AXT is smaller than the width of the main trench TRC. In one or more embodiments, the depth DEP of the auxiliary trench AXT is about 200 Å, and the width WT of the auxiliary trench AXT ranges from about 500 Å to about 1000 Å. The depth DEP of the auxiliary trench AXT is defined as the distance in the third direction DR3 from the bottom surface S1 of the auxiliary trench AXT to the top surface of the first electrode AND. The width WT of the auxiliary trench AXT is defined as the distance between the first electrode AND and the planarization layer PNS adjacent thereto, specifically the distance between the side surface S2 of the first electrode AND and the side surface S1 of the planarization layer PNS.

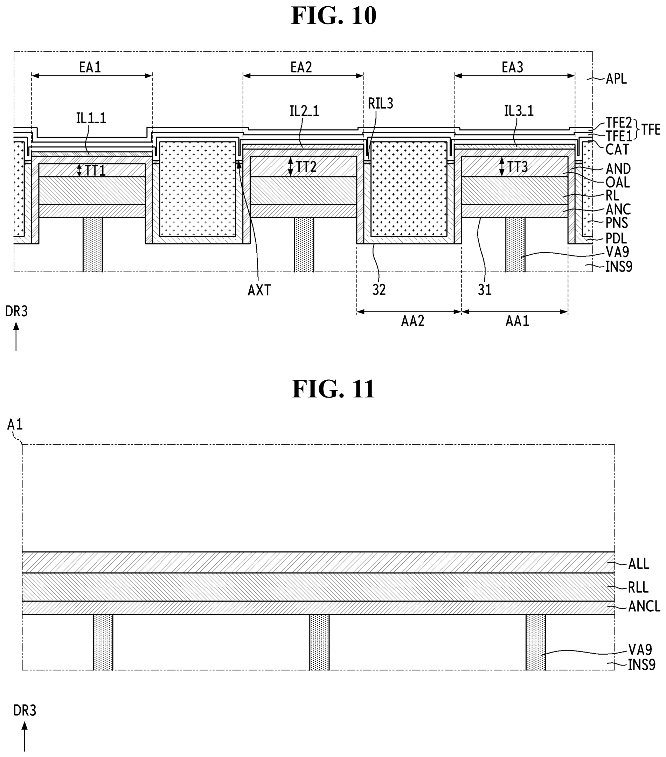

FIG. 10 is a cross-sectional view of a display device of one or more embodiments of the present disclosure.

The display device shown in FIG. 10 does not include the trenches TRC, the first to third color filters CF1, CF2, and CF3, the plurality of lenses LNS, and the filling layer FIL, and differs from the display device 10 of FIG. 8 described above in the structure of the light emitting stack. The following description will mainly focus on this difference.

Referring to FIG. 10, the first emission area EA1 may include a first light emitting layer IL1_1 emitting first light, the second emission area EA2 may include a second light emitting layer IL2_1 emitting second light, and the third emission area EA3 may include a third light emitting layer IL3_1 emitting third light. Although the light emitting stack IL (see FIG. 7 and FIG. 8) includes the charge generation layer between the first stack layer IL1 and the second stack layer IL2, a single light emitting layer is arranged in each of the emission areas EA1, EA2, and EA3 in one or more embodiments of FIG. 10. Therefore, in one or more embodiments of FIG. 10, it is not necessary to cut off the charge generation layer to prevent or reduce an electric current (e.g., a lateral current leakage) from flowing through the charge generation layer. Therefore, the trench TRC may not be provided in one or more embodiments of FIG. 10.

The first light emitting layer IL1_1 may be arranged on the first electrode AND in the first emission area EA1, the second light emitting layer IL2_1 may be arranged on the first electrode AND in the second emission area EA2, and the third light emitting layer IL3_1 may be arranged on the first electrode AND in the third emission area EA3.

The first light emitting layer IL1_1, the second light emitting layer IL2_1, and the third light emitting layer IL3_1 may be spaced and/or apart (e.g., spaced apart or separated) from one another.

Because the first light emitting layer IL1_1 of the first emission area EA1 emits the first light, the second light emitting layer IL2_1 of the second emission area EA2 emits the second light, and the third light emitting layer IL3_1 of the third emission area EA3 emits the third light, the first to third color filters CF1, CF2, and CF3, the plurality of lenses LNS, and the filling layer FIL of the optical layer OPL may not be provided.

In one or more embodiments, because a hole injection layer may be further arranged between each of the first light emitting layer IL1_1, the second light emitting layer IL2_1 and the third light emitting layer IL3_1 and each of the corresponding first electrodes AND, the hole injection layer may be a common layer that is shared by the first light emitting layer IL1_1, the second light emitting layer IL2_1, and the third light emitting layer IL3_1. For example, the hole injection layer may be arranged on each first electrode AND, the pixel defining layer PDL, and the planarization layer PNS. At this time, the hole injection layer may be disconnected by the auxiliary trench AXT, and a residual film RIL3 of the disconnected hole injection layer may be arranged in the auxiliary trench AXT.

FIGS. 11, 12, 13, 14, 15, 16, 17, 18, and 19 are process cross-sectional views illustrating a method for fabricating a display device according to one or more embodiments of the present disclosure. For example, FIGS. 11 to 19 may be process cross-sectional views for describing the method for fabricating the aforementioned display device of FIG. 8.

First, as shown in FIG. 11, after the ninth insulating layer INS9 is formed on the semiconductor substrate SSUB, the ninth vias VA9 may be formed to penetrate the ninth insulating layer INS9. Next, a connection electrode layer ANCL, a reflective electrode layer RLL, and an auxiliary layer ALL may be formed sequentially on the ninth vias VA9 and the ninth insulating layer INS9.

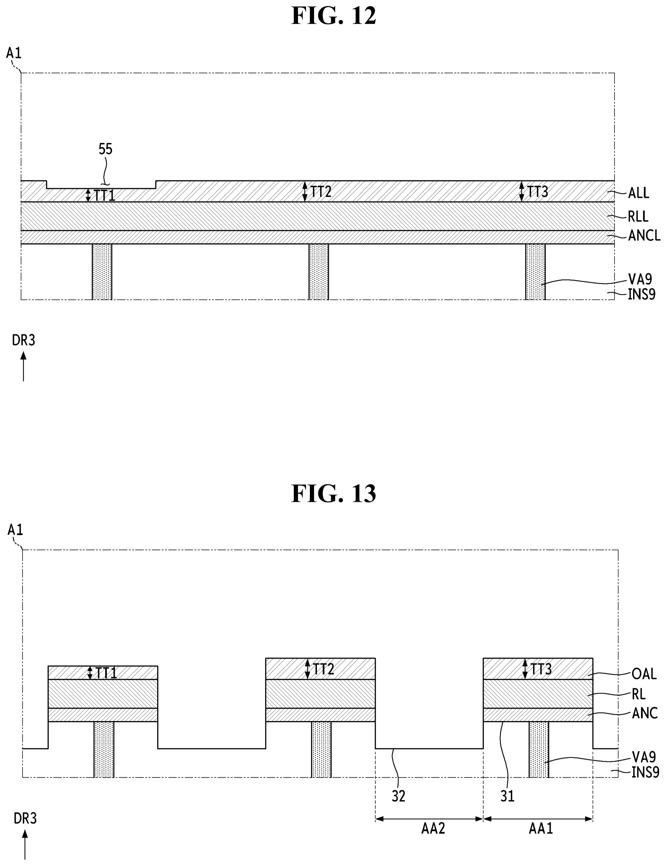

Subsequently, as shown in FIG. 12, a portion of the auxiliary layer ALL corresponding to the first emission area EA1 of the first sub-pixel SP1 is removed to a certain thickness, so that a groove 55 may be formed in the auxiliary layer ALL. The auxiliary layer ALL may have the thickness TT1 of the optical auxiliary layer OAL of the aforementioned first sub-pixel SP1 in a region where the groove 55 is formed. In addition, the auxiliary layer ALL may have the thickness TT2 or TT3 of the optical auxiliary layer OAL of the second or third sub-pixel SP2 or SP3 in a region where the groove 55 is not formed.

Next, as illustrated in FIG. 13, by removing the auxiliary layer ALL, the reflective electrode layer RLL, and the connection electrode layer ANCL in the second region AA2, the plurality of optical auxiliary layers OAL, the plurality of reflective electrodes RL, and the plurality of connection electrodes ANC may be formed in the first region AA1. The thickness of the optical auxiliary layer OAL corresponding to the groove 55 may be smaller than the thickness of other optical auxiliary layers OAL.

In one or more embodiments, when the connection electrode layer ANCL is removed in the second region AA2, a portion of the ninth insulating layer INS9 under the connection electrode layer ANCL may also be removed. Accordingly, the ninth insulating layer INS9 may have the protrusion 31 and the groove 32.

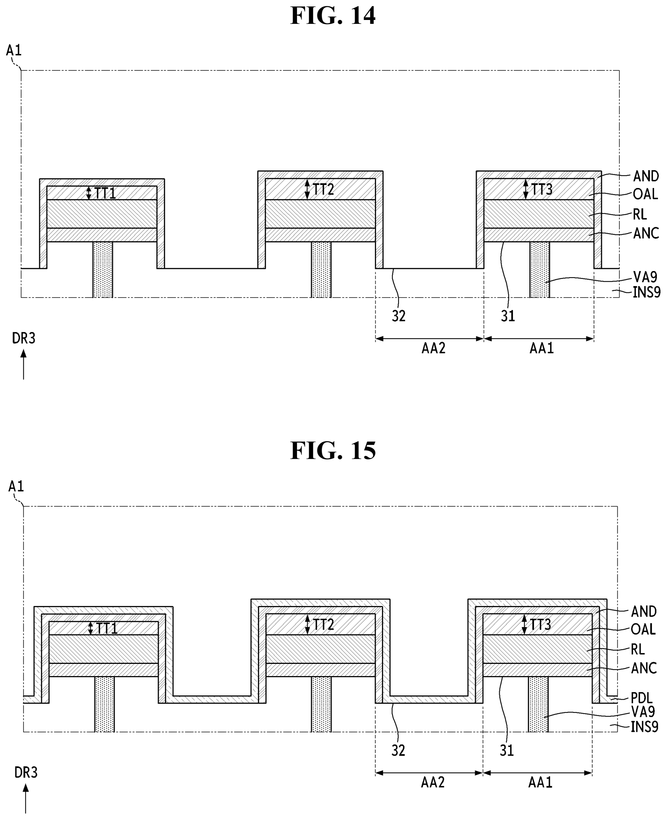

Thereafter, as shown in FIG. 14, the plurality of first electrodes AND may be formed. For example, the first electrode AND may be formed on each optical auxiliary layer OAL. In this regard, the first electrode AND may be formed on the top surface of the optical auxiliary layer OAL, the side surface of the optical auxiliary layer OAL, the side surface of the reflective electrode RL, the side surface of the connection electrode ANC, and the side surface of the protrusion 31 of the ninth insulating layer INS9. Here, the first electrode AND may be in contact with the top surface of the optical auxiliary layer OAL, the side surface of the optical auxiliary layer OAL, the side surface of the reflective electrode RL, the side surface of the connection electrode ANC, and the side surface of the protrusion 31 of the ninth insulating layer INS9.

Subsequently, as shown in FIG. 15, the pixel defining layer PDL (e.g., preliminary pixel defining layer) may be formed on the first electrodes AND. In this regard, the pixel defining layer PDL (e.g., preliminary pixel defining layer) may be arranged on the top surface of each first electrode AND, the side surface of each first electrode AND, and the bottom surface of each groove 32 of the ninth insulating layer INS9. Here, the pixel defining layer PDL (e.g., preliminary pixel defining layer) may be in contact with the top surface of each first electrode AND, the side surface of each first electrode AND, and the bottom surface of each groove 32 of the ninth insulating layer INS9.

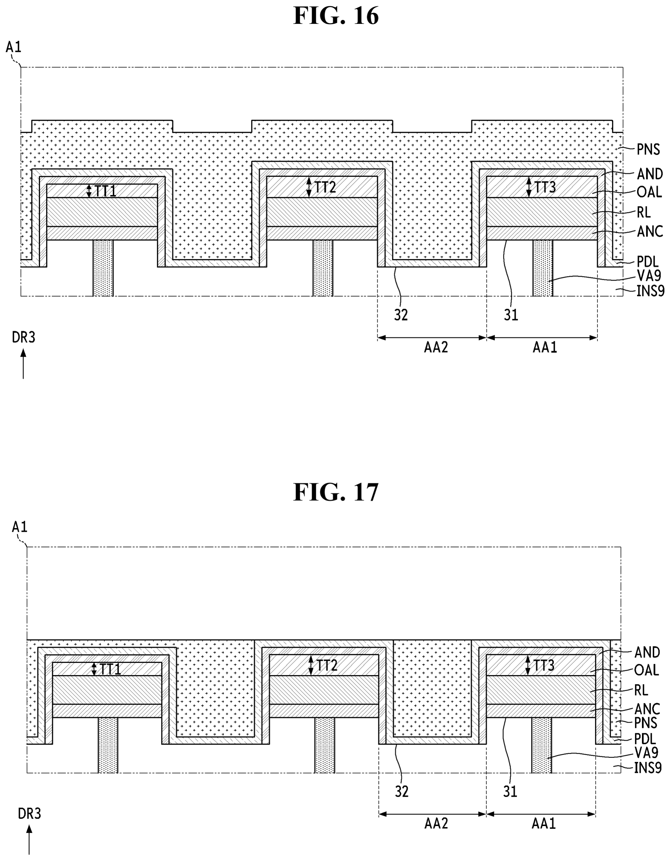

Next, as illustrated in FIG. 16, the planarization layer PNS may be formed on the pixel defining layer PDL (e.g., preliminary pixel defining layer). In this regard, the planarization layer PNS may be formed with a large thickness so that it is positioned higher than the uppermost surface of the pixel defining layer PDL (e.g., preliminary pixel defining layer) in all areas.

Subsequently, as shown in FIG. 17, the planarization layer PNS may be flattened by removing portions of the planarization layer PNS higher than the uppermost surface of the pixel defining layer PDL (e.g., preliminary pixel defining layer). For example, the planarization layer PNS may be planarized by being removed through chemical mechanical polishing. In one or more embodiments, the planarization layer PNS is formed of a silicon oxide (SiOₓ)-based inorganic film, and the pixel defining layer PDL (e.g., preliminary pixel defining layer) is formed of a silicon nitride (SiNₓ)-based inorganic film, so that the pixel defining layer PDL (e.g., preliminary pixel defining layer) may serve as a stopper in the aforementioned polishing process.

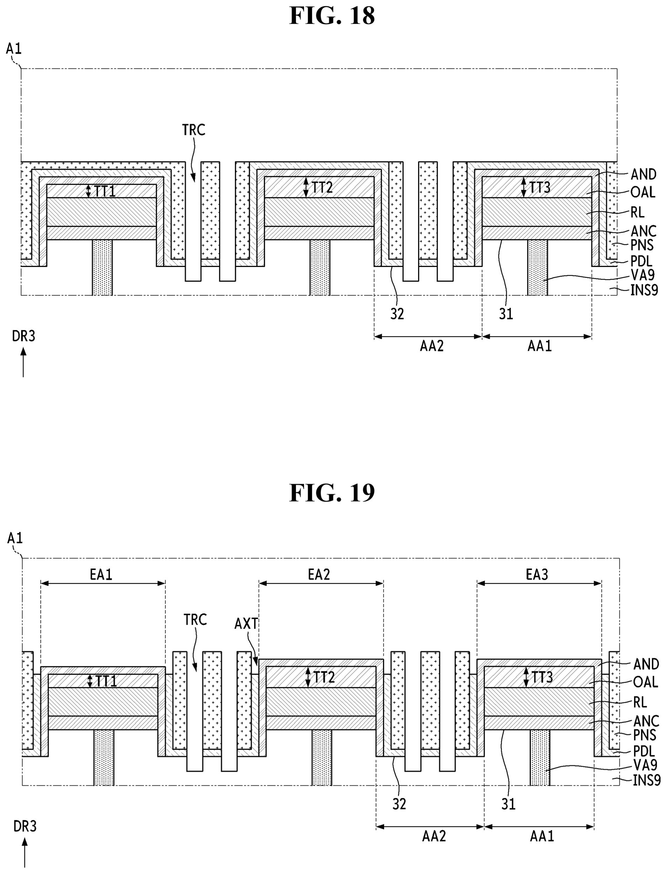

Subsequently, as shown in FIG. 18, the trench TRC may be formed by removing a portion of the ninth insulating layer INS9 and penetrating the planarization layer PNS and the pixel defining layer PDL (e.g., preliminary pixel defining layer) in the second region AA2.

Next, as illustrated in FIG. 19, the planarization layer PNS overlapping the top surface of the first electrode AND and the pixel defining layer PDL (e.g., preliminary pixel defining layer) overlapping the top surface of the first electrode AND are removed, and a portion of the pixel defining layer PDL (e.g., preliminary pixel defining layer) between the side surface of the first electrode AND and the side surface of the planarization layer PNS is removed, so that the pixel defining layer PDL defining the first emission area EA1, the second emission area EA2, and the third emission area EA3 may be formed, and, also, the auxiliary trench AXT may be formed. For example, by removing the planarization layer PNS and the pixel defining layer PDL (e.g., preliminary pixel defining layer) in the first region AA1 and removing a portion of the pixel defining layer PDL (e.g., preliminary pixel defining layer) in the second region AA2, the auxiliary trench AXT and the pixel defining layer PDL defining the emission areas EA1, EA2, and EA3 may be formed.

Next, as shown in FIG. 8, the first stack layer IL1 may be formed on the first electrodes AND and the planarization layer PNS, the second stack layer IL2 may be formed on the first stack layer IL1, the second electrode CAT may be formed on the second stack layer IL2, the first encapsulation inorganic layer TFE1 may be formed on the second electrode CAT, the second encapsulation inorganic layer TFE2 may be formed on the first encapsulation inorganic layer TFE1, and the organic layer APL may be formed on the second encapsulation inorganic layer TFE2.

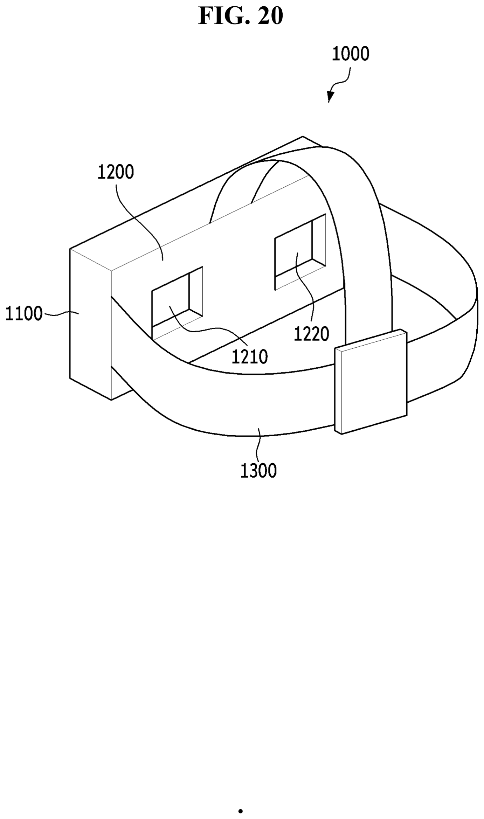

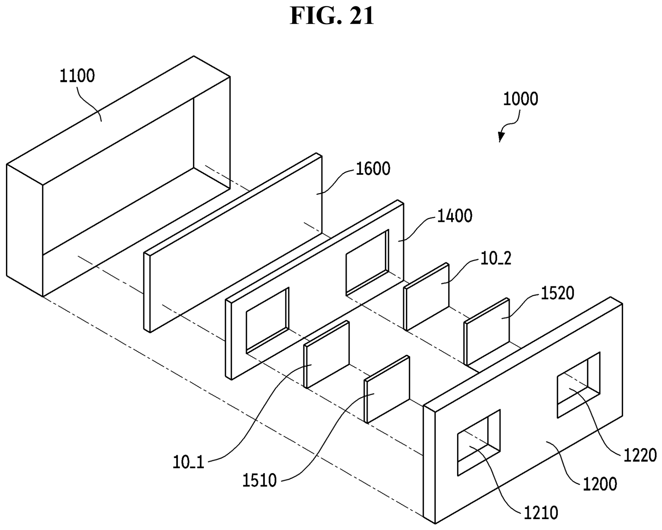

FIG. 20 is a perspective view illustrating a head mounted display according to one or more embodiments of the present disclosure. FIG. 21 is an exploded perspective view illustrating an example of the head mounted display of FIG. 20. For example, FIG. 20 and FIG. 21 show a head mounted display as an example of an optical device.

Referring to FIG. 20 and FIG. 21, a head mounted display 1000 according to one or more embodiments includes a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_1 provides an image to a user's left eye, and the second display device 10_2 provides an image to a user's right eye. Because each of the first display device 10_1 and the second display device 10_2 is substantially the same as the display device 10 described in conjunction with FIGS. 1 to 19, description of the first display device 10_1 and the second display device 10_2 will not be provided.

The first optical member 1510 may be arranged between the first display device 10_1 and the first eyepiece 1210. The second optical member 1520 may be arranged between the second display device 10_2 and the second eyepiece 1220. Each of the first optical member 1510 and the second optical member 1520 may include at least one convex lens.

The middle frame 1400 may be arranged between the first display device 10_1 and the control circuit board 1600 and between the second display device 10_2 and the control circuit board 1600. The middle frame 1400 serves to support and fix the first display device 10_1, the second display device 10_2, and the control circuit board 1600.

The control circuit board 1600 may be arranged between the middle frame 1400 and the display device housing 1100. The control circuit board 1600 may be connected to the first display device 10_1 and the second display device 10_2 through a connector. The control circuit board 1600 may convert an image source inputted from the outside into the digital video data DATA, and transmit the digital video data DATA to the first display device 10_1 and the second display device 10_2 through the connector.

In one or more embodiments, the control circuit board 1600 may be to transmit the digital video data DATA corresponding to a left-eye image improved or optimized for the user's left eye to the first display device 10_1, and may be to transmit the digital video data DATA corresponding to a right-eye image improved or optimized for the user's right eye to the second display device 10_2. In one or more embodiments, the control circuit board 1600 may be to transmit the same digital video data DATA to the first display device 10_1 and the second display device 10_2.

The display device housing 1100 serves to accommodate the first display device 10_1, the second display device 10_2, the middle frame 1400, the first optical member 1510, the second optical member 1520, and the control circuit board 1600. The housing cover 1200 is arranged to cover one open surface of the display device housing 1100. The housing cover 1200 may include the first eyepiece 1210 at which the user's left eye looks and the second eyepiece 1220 at which the user's right eye looks. FIG. 20 and FIG. 21 illustrate that the first eyepiece 1210 and the second eyepiece 1220 are arranged separately, but embodiments of the present disclosure are not limited thereto. The first eyepiece 1210 and the second eyepiece 1220 may be combined into one.

The first eyepiece 1210 may be aligned with the first display device 10_1 and the first optical member 1510, and the second eyepiece 1220 may be aligned with the second display device 10_2 and the second optical member 1520. Therefore, the user may view, through the first eyepiece 1210, the image of the first display device 10_1 magnified as a virtual image by the first optical member 1510, and may view, through the second eyepiece 1220, the image of the second display device 10_2 magnified as a virtual image by the second optical member 1520.

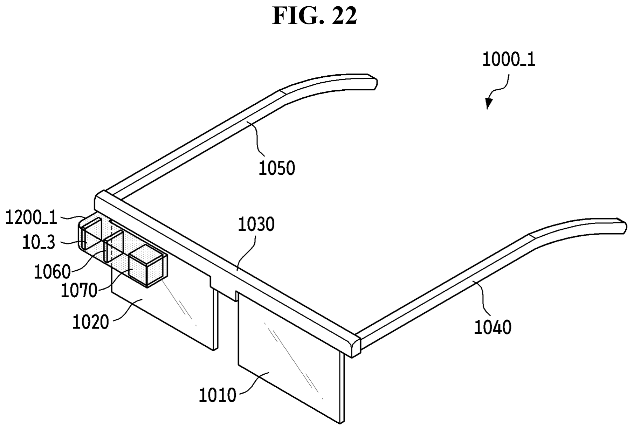

The head mounted band 1300 serves to secure the display device housing 1100 to the user's head such that the first eyepiece 1210 and the second eyepiece 1220 of the housing cover 1200 remain located on the user's left and right eyes, respectively. In one or more embodiments, when the display device housing 1200 is implemented to be lightweight and compact, the head mounted display 1000 may be provided with an eyeglass frame as shown in FIG. 22 instead of the head mounted band 1300.

In one or more embodiments, the head mounted display 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 22 is a perspective view illustrating a head mounted display according to one or more embodiments of the present disclosure. For example, FIG. 22 illustrates a head mounted display in the form of glasses as an example of an optical device.

Referring to FIG. 22, a head mounted display 1000_1 according to one or more embodiments may be an eyeglasses-type (kind) display device in which a display device housing 1200_1 is implemented in a lightweight and compact manner. The head mounted display 1000_1 according to one or more embodiments may include a display device 10_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 10_3, the optical member 1060, and the optical path changing member 1070. An image displayed on the display device 10_3 may be magnified by the optical member 1060, and may be provided to the user's right eye through the right eye lens 1020 after the optical path thereof is changed by the optical path changing member 1070. As a result, the user may view an augmented reality image, through the right eye, in which a virtual image displayed on the display device 10_3 and a real image seen through the right eye lens 1020 are combined.

FIG. 22 illustrates that the display device housing 1200_1 is arranged at the right end of the support frame 1030, but embodiments of the present disclosure are not limited thereto. For example, in one or more embodiments, the display device housing 1200_1 may be arranged at the left end of the support frame 1030, and in these embodiments, the image of the display device 10_3 may be provided to the user's left eye. In one or more embodiments, the display device housing 1200_1 may be arranged at both (e.g., simultaneously) the left and right ends of the support frame 1030, and in these embodiments, the user may view the image displayed on the display device 10_3 through both (e.g., simultaneously) the left and right eyes.

The display device 10 according to one or more embodiments may be applied to one or more suitable electronic devices. An electronic device according to one or more embodiments may include the above-described display device 10, and may further include, in addition to the display device 10, a module or device having other additional functions.

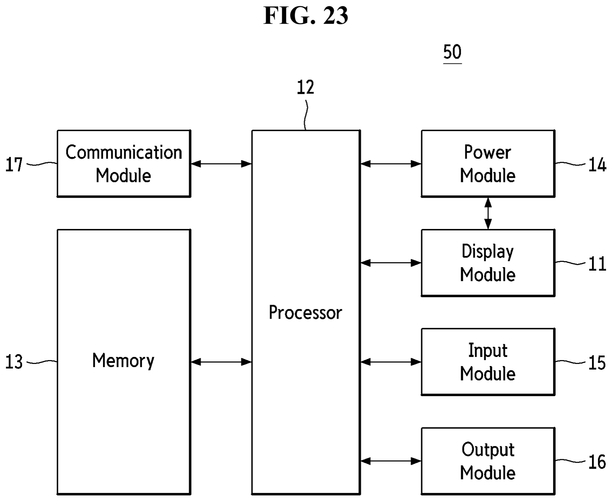

FIG. 23 is a block diagram of an electronic device according to one or more embodiments of the present disclosure. Referring to FIG. 23, an electronic device 50 according to one or more embodiments may include a display module 11, a processor 12, a memory 13, and a power module 14. The electronic device 50 may further include an input module 15, a non-visual output module 16, and/or a communication module 17.

The electronic device 50 may output one or more suitable information in the form of images through the display module 11. When the processor 12 executes an application stored in memory 13, image information provided by the application may be provided to a user through the display module 11. The power module 14 may include a power supply module, such as a power adapter or a battery device, and a power conversion module that converts the power supplied by the power supply module to generate the power desired or required for the operation of the electronic device 50. The input module 15 may provide input information to the processor 12 and/or the display module 11. The non-visual output module 16 may serve to receive information other than images, such as sound, haptics, luminescence, and/or the like, sent from the processor 12, and provide it to the user. The communication module 17 is a module responsible for the transmission and reception of information between the electronic device 50 and an external device, and may include a receiver and a transmitter.

At least one of the components of the above-described electronic device 50 may be included in the display device according to one or more embodiments described above. In one or more embodiments, some of the individual modules that are functionally included in a single module may be included in the display device, whereas some others thereof may be provided separately from the display device. For example, in one or more embodiments, the display device may include the display module 11, whereas the processor 12, the memory 13, and the power module 14 may be provided in the form of other devices in the electronic device 50, other than the display device.

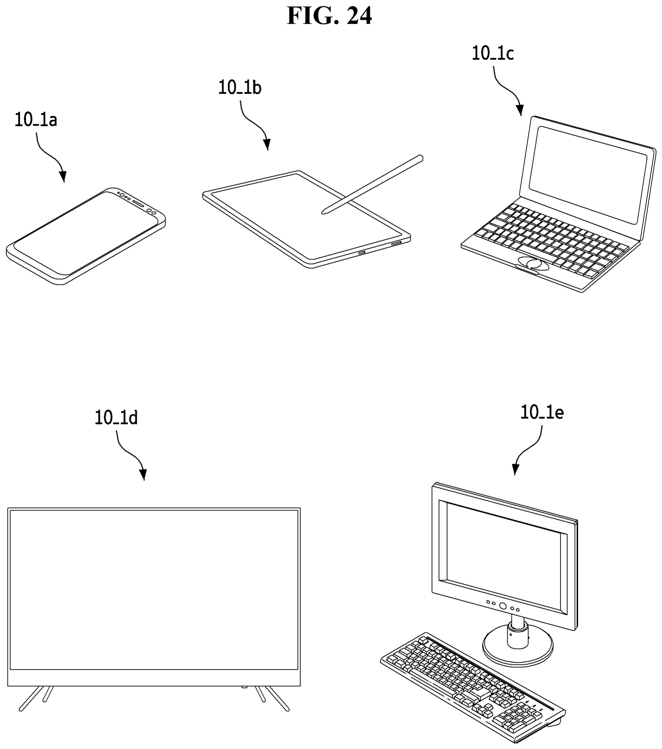

FIGS. 24, 25, and 26 are each a schematic diagram illustrating electronic devices according to one or more suitable embodiments. FIGS. 24 to 26 illustrate examples of one or more suitable electronic devices to which the display device 10 according to the above-described embodiments are applied.

FIG. 24 shows a smartphone 10_1a, a tablet PC 10_1b, a laptop 10_1c, a TV 10_1d, and a desk monitor 10_1e as examples of electronic devices.

The smartphone 10_1a may include a communication module and an input module such as a touch sensor, and/or the like, in addition to the display module 11. The smartphone 10_1a may process the information received through the communication module or input module and display the processed information through the display module of the display device.

Each of the tablet PC 10_1b, the laptop 10_1c, the TV 10_1d, and the desk monitor 10_1e may include a display and an input module, similarly to the smartphone 10_1a, and may further include a communication module in some cases.

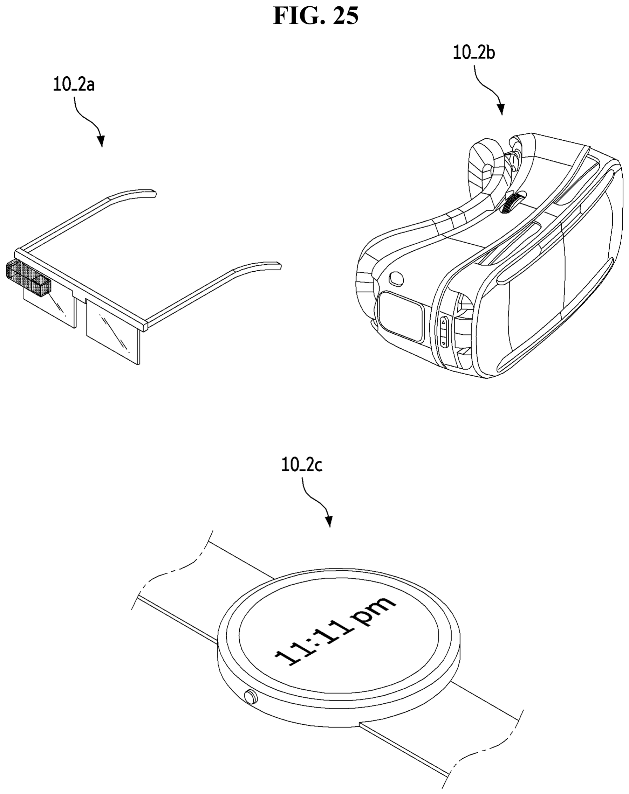

FIG. 25 illustrates embodiments in which an electronic device including a display module is applied to a wearable electronic device. The wearable electronic device may be smart glasses 10_2a, a head mounted display 10_2b, a smart watch 10_2c, and/or the like.

The smart glasses 10_2a and the head mounted display 10_2b may include a display module that outputs an image and a reflector that reflects the outputted image to provide it to the user's eyes, thereby providing a virtual reality and/or augmented reality screen to the user.

The smart watch 10_2c may include a biometric sensor as an input device, and may provide biometric information recognized through the biometric sensor to the user through a display module.

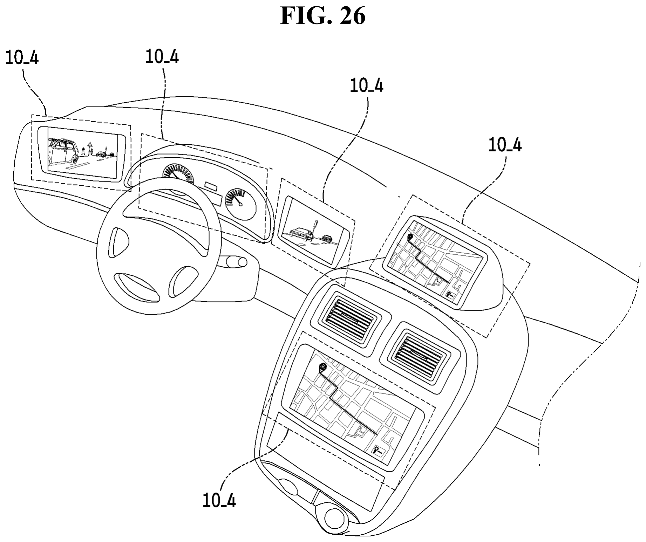

FIG. 26 illustrates embodiments in which an electronic device including a display module is applied to a vehicle. For example, an electronic device 10_4 may be applied to a dashboard or center fascia of a vehicle, or to a center information display (CID) placed in the dashboard of the vehicle or a room mirror display that replaces a side mirror.

In the present disclosure, it will be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

In the present disclosure, expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof.

In the context of the present application and unless otherwise defined, the terms "use," "using," and "used" may be considered synonymous with the terms "utilize," "utilizing," and "utilized," respectively.

As utilized herein, the terms "substantially," "about," "approximately," or similar terms are used as terms of approximation and not as terms of degree, and are intended to account for the inherent deviations in measured or calculated values that would be recognized by those of ordinary skill in the art. "About" or "approximately" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

The light emitting element, the display module, the display device, the electronic device/apparatus, the device-manufacturing apparatus, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In concluding the detailed description, those skilled in the art will appreciate that many variations and modifications may be made to the presented embodiments without substantially departing from the principles of the disclosure. Therefore, the disclosed embodiments of the present disclosure are used in a generic and descriptive sense only and not for purposes of limitation. It is to be understood that the scope of the present disclosure is defined by the appended claims and equivalents thereof rather than the detailed description described above, and all modifications and alterations derived from the claims and their equivalents fall within the scope of the present disclosure.

## Claims

1. A display device (10) comprising:
a substrate (SSUB);
a reflective electrode (RL) on the substrate (SSUB);
an optical auxiliary layer (OAL) on the reflective electrode (RL);
a first electrode (AND) on the optical auxiliary layer (OAL);
a light emitting stack (IL) on the first electrode (AND);
a second electrode (CAT) on the light emitting stack (IL);
a pixel defining layer (PDL) arranged between adjacent first electrodes (AND);
a planarization layer (PNS) on the pixel defining layer (PDL); and
an auxiliary trench (AXT) defined by a top surface (S1) of the pixel defining layer (PDL), a side surface (S2) of the first electrode (AND), and a side surface (S3) of the planarization layer (PNS).

2. The display device (10) of claim 1, wherein the top surface (S1) of the pixel defining layer (PDL) is at a height lower than those of a top surface of the first electrode (AND) and a top surface of the planarization layer (PNS).

3. The display device (10) of claim 1 or claim 2, further comprising a residual film (RIL2) in the auxiliary trench (AXT).

4. The display device (10) of claim 3, wherein the residual film (RIL2) comprises a same material as a portion of the light emitting stack (IL).

5. The display device (10) of any preceding claim, further comprising a trench (TRC) penetrating the planarization layer (PNS) and the pixel defining layer (PDL).

6. The display device (10) of claim 5, wherein a width (WT) of the auxiliary trench (AXT) is smaller than a width of the trench (TRC).

7. The display device (10) of claim 5 or claim 6, wherein a depth (DEP) of the auxiliary trench (AXT) is smaller than a depth of the trench (TRC).

8. The display device (10) of any preceding claim, wherein:
(i) a width (WT) of the auxiliary trench (AXT) is about 500 Å to about 1000 Å; and/or
(ii) a depth (DEP) of the auxiliary trench (AXT) is about 200 Å.

9. The display device (10) of any preceding claim, wherein at least a portion of the light emitting stack (IL) is cut in the auxiliary trench (AXT).

10. An electronic device comprising:
a display device (10) comprising a screen,
wherein the display device (10) comprises:
a substrate (SSUB);
a reflective electrode (RL) on the substrate (SSUB);
an optical auxiliary layer (OAL) on the reflective electrode (RL);
a first electrode (AND) on the optical auxiliary layer (OAL);
a light emitting stack (IL) on the first electrode (AND);
a second electrode (CAT) on the light emitting stack (IL);
a pixel defining layer (PDL) arranged between adjacent first electrodes (AND);
a planarization layer (PNS) on the pixel defining layer (PDL); and
an auxiliary trench (AXT) defined by a top surface (S1) of the pixel defining layer (PDL), a side surface (S2) of the first electrode (AND), and a side surface (S3) of the planarization layer (PNS).

11. The electronic device of claim 10, wherein the top surface of the pixel defining layer (PDL) is at a height lower than those of a top surface of the first electrode (AND) and a top surface of the planarization layer (PNS).

12. The electronic device of claim 10 or claim 11, further comprising a residual film (RIL2) in the auxiliary trench (AXT);
optionally wherein the residual film (RIL2) comprises a same material as a portion of the light emitting stack (IL).

13. The electronic device of any of claims 10-12, further comprising a trench (TRC) penetrating the planarization layer (PNS) and the pixel defining layer (PDL).

14. The electronic device of claim 13, wherein:
(i) a width (WT) of the auxiliary trench (AXT) is smaller than a width of the trench (TRC); and/or
(ii) a depth (DEP) of the auxiliary trench (AXT) is smaller than a depth (DEP) of the trench (TRC).

15. The electronic device of any of claims 10-14, wherein:
(i) a width (WT) of the auxiliary trench (AXT) is about 500 Å to about 1000 Å; and/or
(ii) a depth (DEP) of the auxiliary trench (AXT) is about 200 Å; and/or
(iii) at least a portion of the light emitting stack (IL) is cut in the auxiliary trench (AXT).
